(19) Europäisches Patentamt
European Patent Office
Office européen des brevets

(11) **EP 3 264 234 A1**

(12) **EUROPEAN PATENT APPLICATION**
published in accordance with Art. 153(4) EPC

(43) Date of publication:
**03.01.2018 Bulletin 2018/01**

(21) Application number: **16755709.9**

(22) Date of filing: **26.02.2016**

(51) Int Cl.:
***G06F 3/041*** *(2006.01)* ***G06F 3/044*** *(2006.01)*
***H05K 1/02*** *(2006.01)*

(86) International application number:
**PCT/JP2016/055894**

(87) International publication number:
**WO 2016/136965 (01.09.2016 Gazette 2016/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **27.02.2015 JP 2015038639**

(71) Applicant: **Fujikura Ltd.**
**Tokyo 135-8512 (JP)**

(72) Inventor: **OGURA, Shingo**
**Sakura-shi,**
**Chiba 285-8550 (JP)**

(74) Representative: **Ter Meer Steinmeister & Partner**
**Patentanwälte mbB**
**Artur-Ladebeck-Strasse 51**
**33617 Bielefeld (DE)**

# (54) WIRING BODY, WIRING SUBSTRATE, AND TOUCH SENSOR

(57) A wiring body (40) includes: a first conductor layer (60); a second conductor layer (80); and a second resin layer (70) interposed between the first and second conductor layers (60, 80). The first conductor layer (60) includes at least: a first electrode (61); a first lead wire (62) electrically connected to the first electrode (61); and a first shield layer (63) electrically insulated from the first electrode (61) and the first lead wire (62). The second conductor layer (80) includes at least: a second electrode (81) disposed to face the first electrode (61); and a second lead wire (82) electrically connected to the second electrode (82). The first electrode (61), the first lead wire (62), and the first shield layer (63) are formed on substantially same plane. The second electrode (81) and the second lead wire (82) are formed on substantially same plane. At least a part of the second lead wire (82) overlaps the first shield layer (63) in a plan view. The first conductor layer (60) includes a noncontact surface (613, 621, 631) that is not in contact with the second resin layer (70). The first conductor layer (60) is embedded in the second resin layer (80) except the noncontact surface (613, 621,631). The second conductor layer (80) is provided on the second resin (80). The first shield layer (63) includes a shield line (631). The shield line (631) has a tapered shape that narrows toward a side approaching the second lead wire (82). The second lead wire (82) has a tapered shape that narrows toward a side departing from the shield line (631).

Fig.3

20
40
82
81(811)
82
814
815
812a(812b)
822
823
C2
80
71
821
813
72
63
61(611)
63
B2
70
631a(631b)
633
614
615
612a(612b)
633
634
631a(631b)
C1,W2
W1
60
634
51
632
613
632
50
B1
31A
52
30A
93
32A
90
Z
Y
X

EP 3 264 234 A1

## Description

[Technical Field]

The present invention relates to a wiring body, a wiring board, and a touch sensor.

The contents of Patent Application No. 2015-038639, filed with Japan Patent Office on February 27, 2015, are incorporated herein by reference in the designated countries in which the incorporation by reference is accepted.

[Background Art]

A touch sensor is known in which two electrode boards are disposed to face each other via an insulation material and a contact position from external is detected using the capacitance between electrodes. In such a touch sensor, there is known a technique of forming a lead wire above a shield layer, which is formed on the same plane as an electrode, via an insulation layer (see Patent Document 1, for example).

[Prior Art Document]

[Patent Document]

[Patent Document 1] JP2009-169720A

[Summary of Invention]

[Problems to be solved by Invention]

Unfortunately, the above technique has a problem in that the height (thickness) of a wiring body increases, because the insulation layer has to be interposed between the lead wire and the shield layer for each electrode board.

Problems to be solved by the present invention include providing a wiring body, a wiring board, and a touch sensor that are able to suppress increase of the height (thickness).

[Means for solving problems]

<1> The wiring body according to the present invention comprises: a first conductor layer; a second conductor layer; and a first insulation layer interposed between the first and second conductor layers. The first conductor layer includes at least: a first electrode; a first lead wire electrically connected to the first electrode; and a first shield layer electrically insulated from the first electrode and the first lead wire. The second conductor layer includes at least: a second electrode disposed to face the first electrode, and a second lead wire electrically connected to the second electrode. The first electrode, the first lead wire, and the first shield layer are formed on substantially the same plane. The second electrode and the second lead wire are formed on substantially the same plane. At least a part of the second lead wire overlaps the first shield layer in a plan view. The first conductor layer includes a noncontact surface that is not in contact with the first insulation layer. The first conductor layer is embedded in the first insulation layer except the noncontact surface. The second conductor layer is provided on the first insulation layer. The first shield layer includes a conductor line. The conductor line has a tapered shape that narrows toward a side approaching the second lead wire. The second lead wire has a tapered shape that narrows toward a side departing from the conductor line.

<2> In the above invention, the second conductor layer may further include a second shield layer electrically insulated from the second electrode and the second lead wire and formed on substantially the same plane as the second electrode and the second lead wire, and at least a part of the first lead wire may overlap the second shield layer in the plan view.

<3> In the above invention, at least one of the first and second shield layers may be formed in a mesh-like shape.

<4> In the above invention, a surface roughness of the noncontact surface of the first conductor layer may be relatively rougher than a surface roughness of other surfaces than the noncontact surface of the first conductor layer.

<5> In the above invention, a following Expression (1) may be satisfied:

$$0.5 \leq A \ldots (1).$$

In the above Expression (1), A is a maximum value of C/B, B is a width of the first conductor layer in its cross-sectional view, and C is a height of the first conductor layer in its cross-sectional view.

<6> In the above invention, the wiring body may further comprise a second insulation layer covering at least one of the first and second conductor layers.

<7> The wiring board according to the present invention comprises: the above wiring body; and a support body supporting the wiring body.

<8> In the above invention, the wiring board may further comprise a third insulation layer interposed between the wiring body and the support body.

<9> The touch sensor according to the present invention comprises the above wiring board.

[Effect of Invention]

According to the present invention, in the first and second conductor layers which face each other via the first insulation layer, the first shield layer of the first conductor layer as one conductor layer shields the second lead wire of the second conductor layer as the other conductor layer. It is thus not necessary to separately ensure the insulation between the first shield layer and the second lead wire, and the height (thickness) of the wiring body and the wiring board can be suppressed from increasing.

[Brief Description of Drawings]

FIG. 1 is an exploded perspective view illustrating a touch sensor in an embodiment of the present invention.
FIG. 2 is an exploded perspective view illustrating a wiring board in an embodiment of the present invention.
FIG. 3 is a cross-sectional view along line III-III of FIG. 2.
FIG. 4 is a partial cross-sectional view of a central part along line IV-IV of FIG. 2.
FIG. 5 is a plan view illustrating a first conductor layer in an embodiment of the present invention.
FIG. 6 is an enlarged plan view illustrating a modified example of the first conductor layer in an embodiment of the present invention.
FIG. 7 is a cross-sectional view illustrating a first electrode line in an embodiment of the present invention.
FIG. 8 is a cross-sectional view for describing a first electrode line in an embodiment of the present invention.
FIG. 9 is a plan view illustrating a second conductor layer in an embodiment of the present invention.
FIG. 10 is a cross-sectional view illustrating a second electrode line in an embodiment of the present invention.
FIG. 11 is a plan view illustrating a cover panel in an embodiment of the present invention.
FIG. 12(a) is an enlarged plan view of part XIIa of FIG. 2, and FIG. 12(b) is an enlarged plan view of part XIIb of FIG. 2.
FIG. 13(a) to FIG. 13(e) are cross-sectional views for describing a production method (part 1) for a wiring board in an embodiment of the present invention.
FIG. 14(a) to FIG. 14(f) are cross-sectional views for describing the production method (part 2) for a wiring board in an embodiment of the present invention.

[Mode(s) for Carrying out the Invention]

Hereinafter, one or more embodiments of the present invention will be described with reference to the drawings.

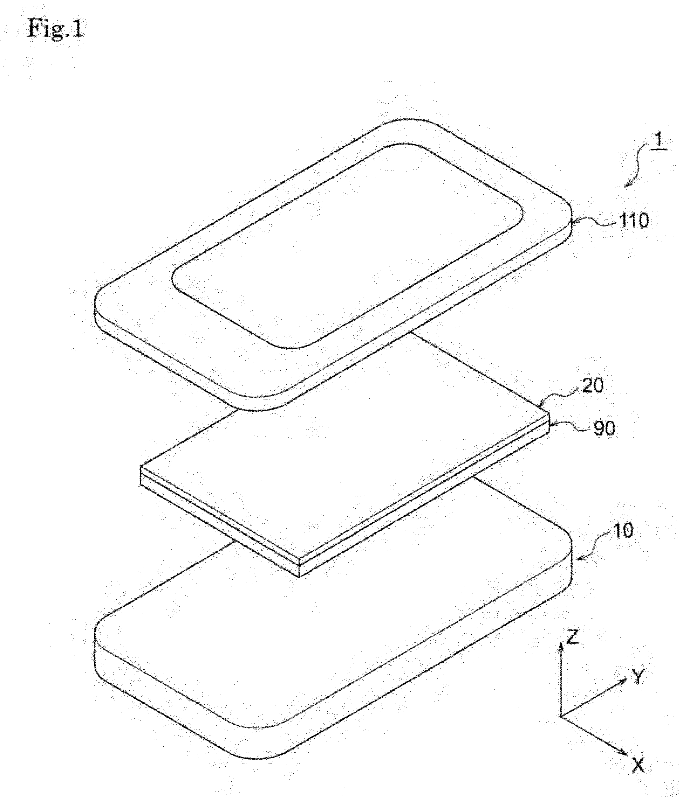

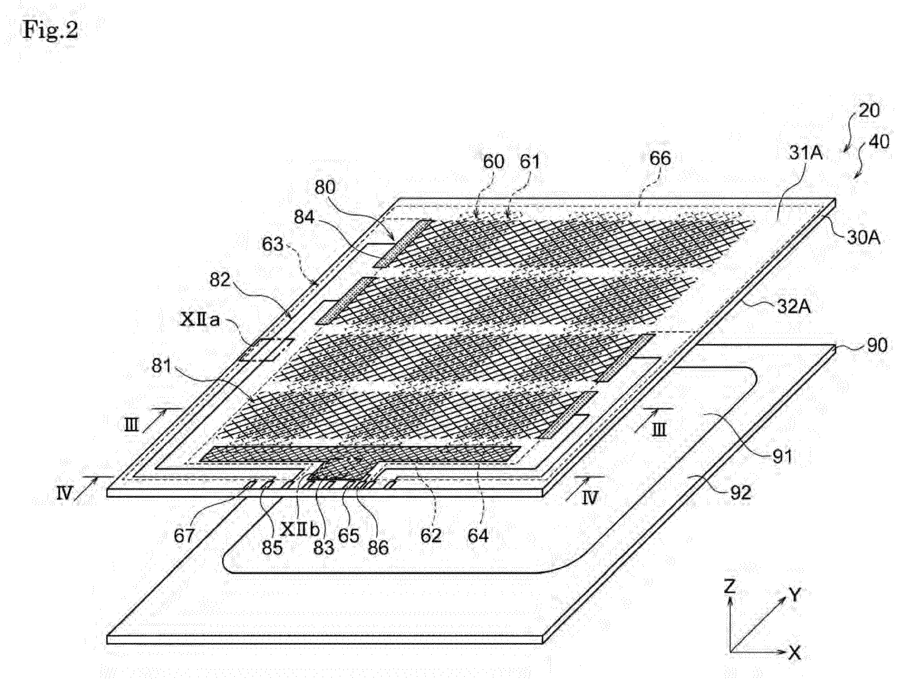

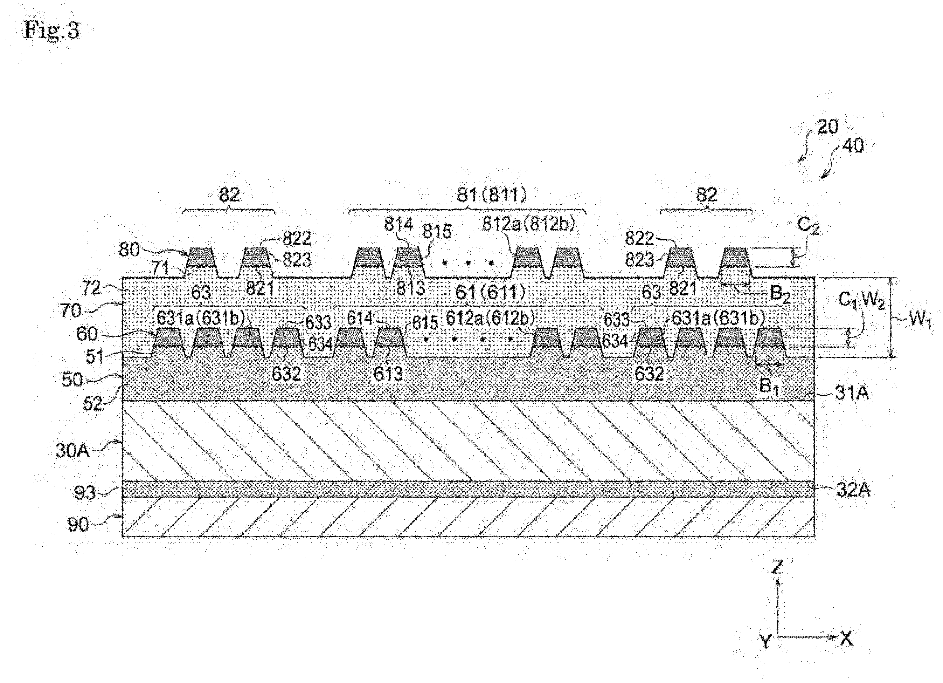

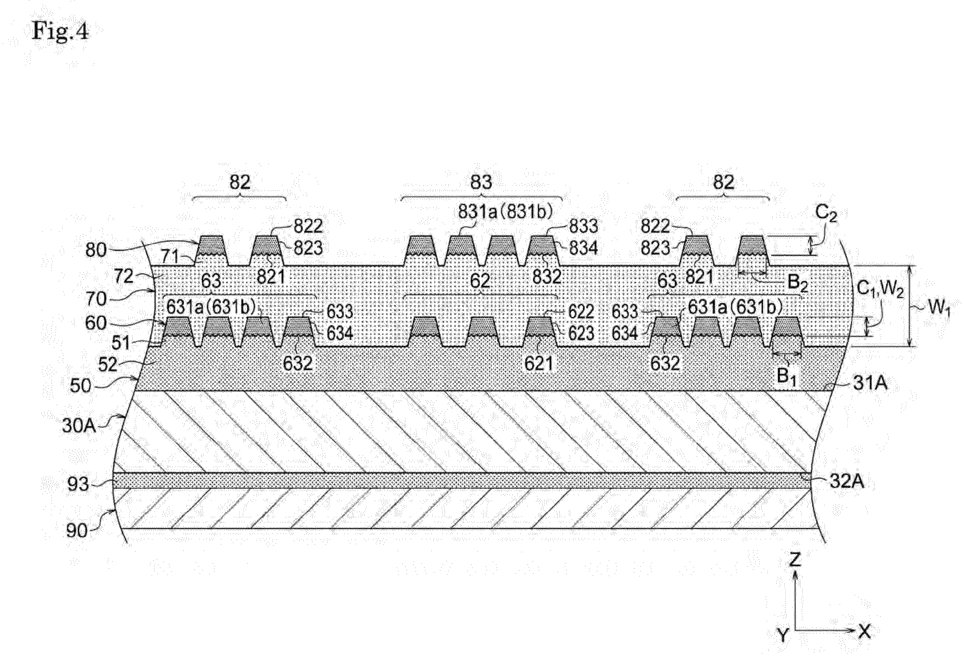

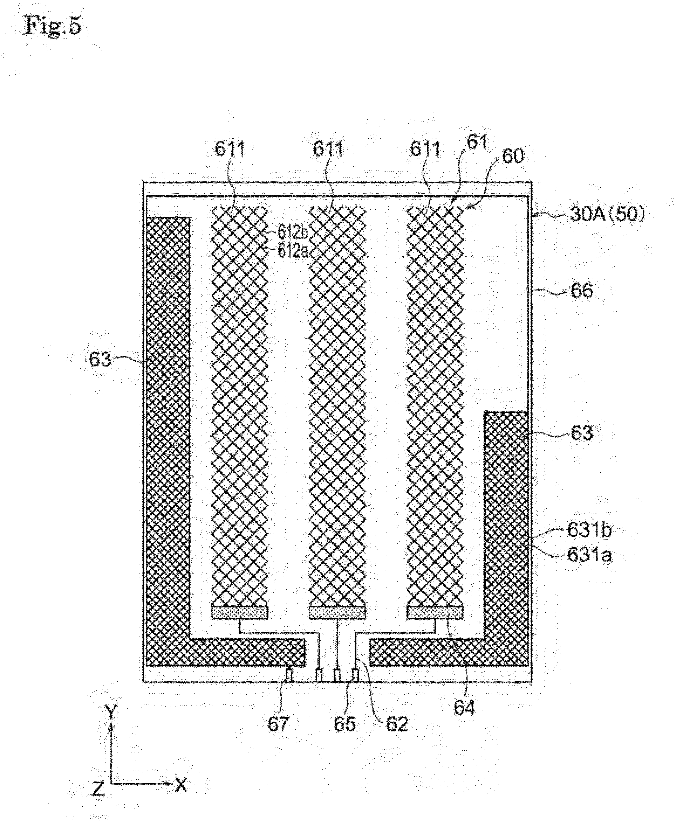

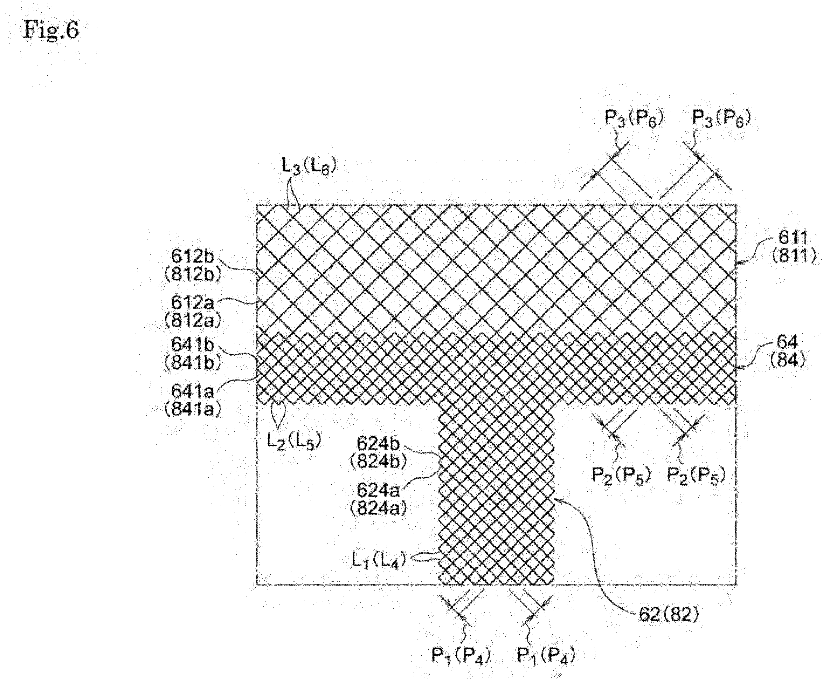

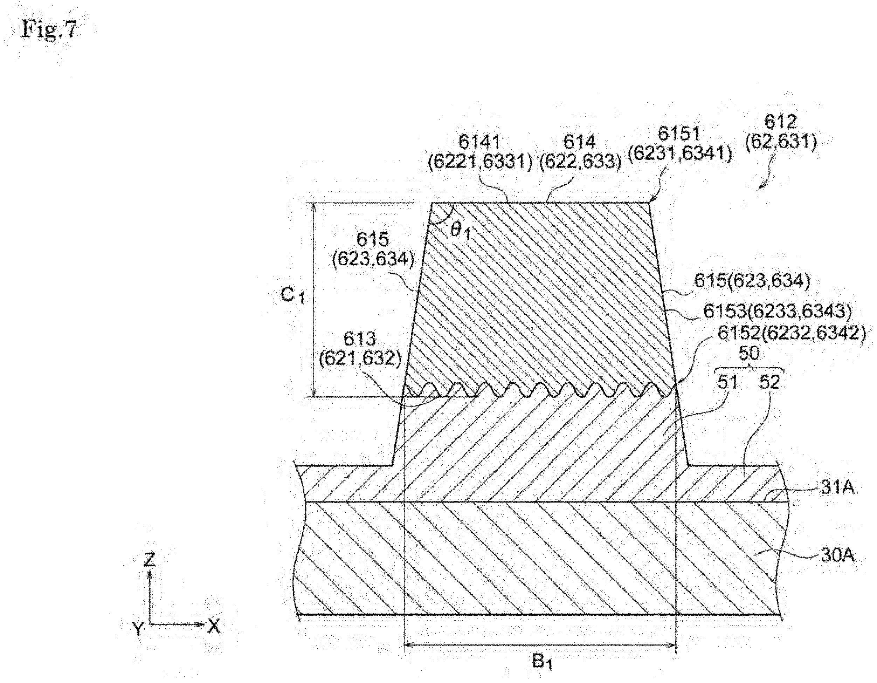

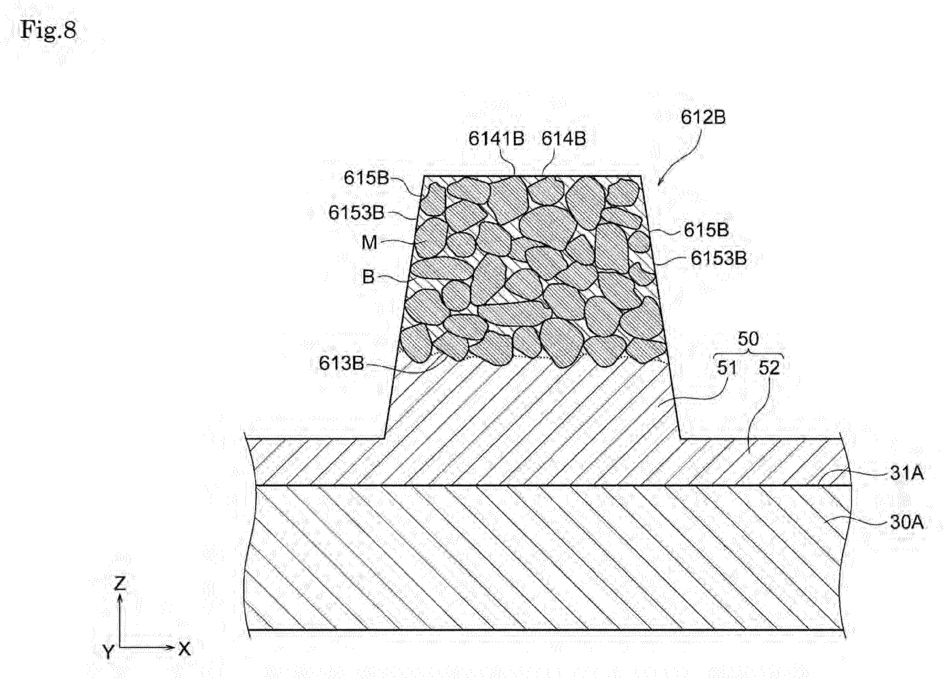

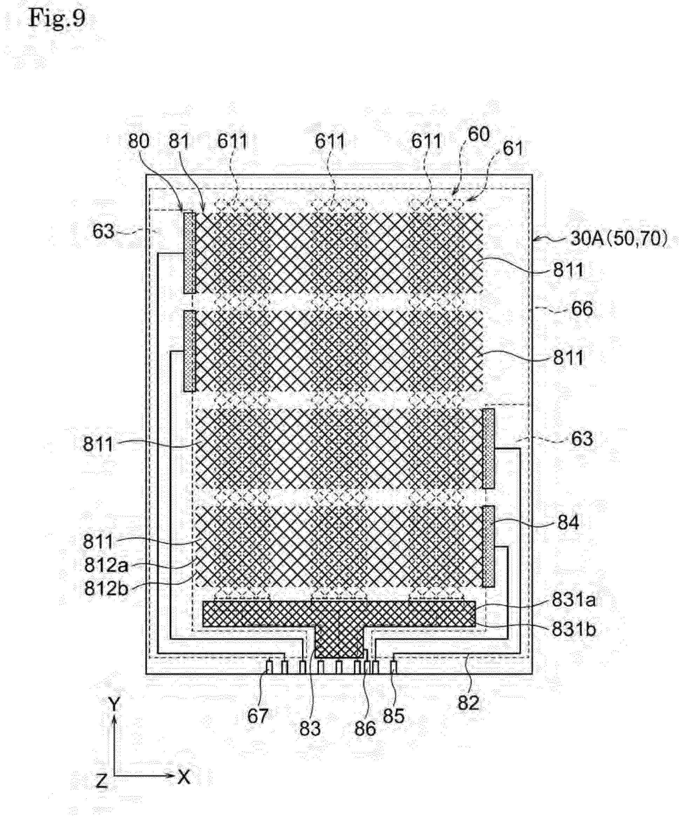

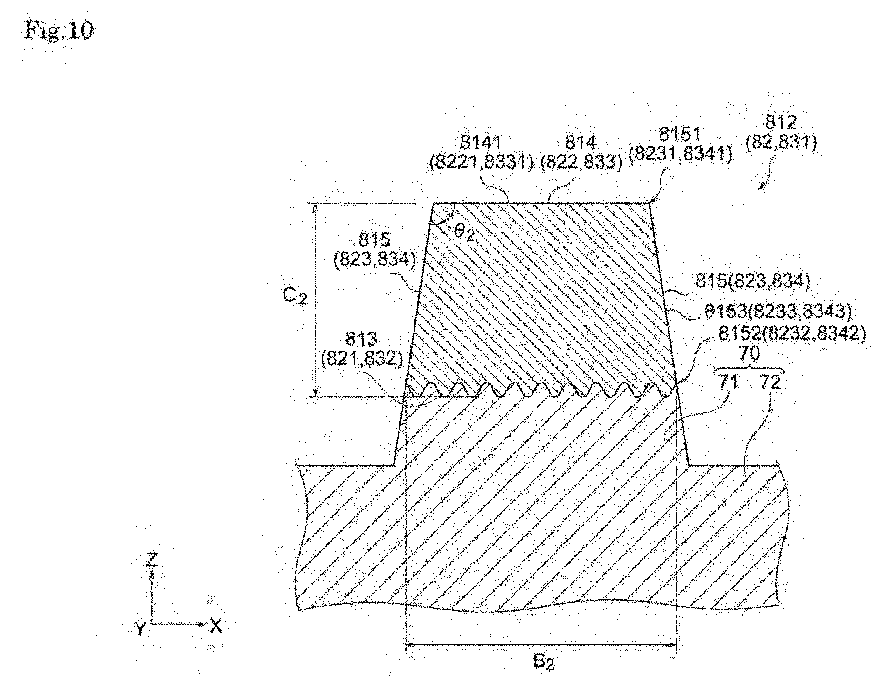

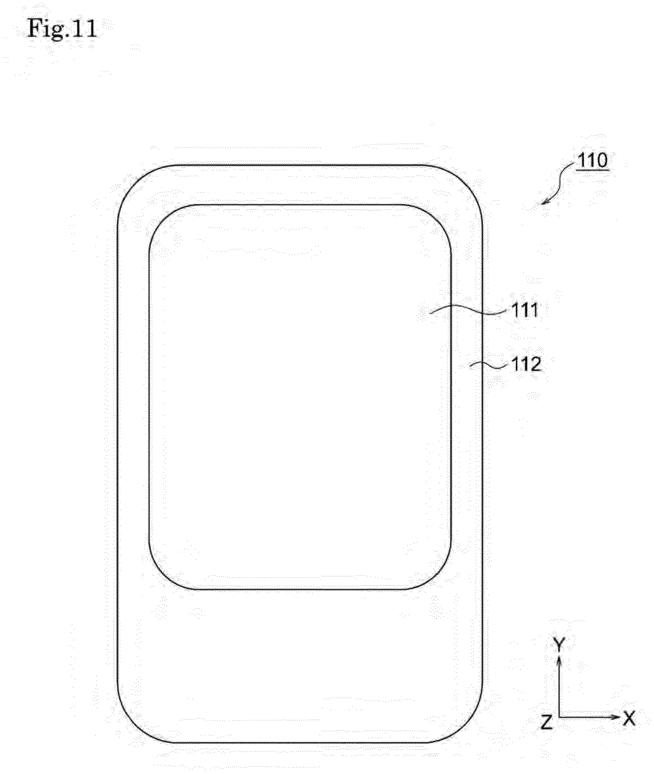

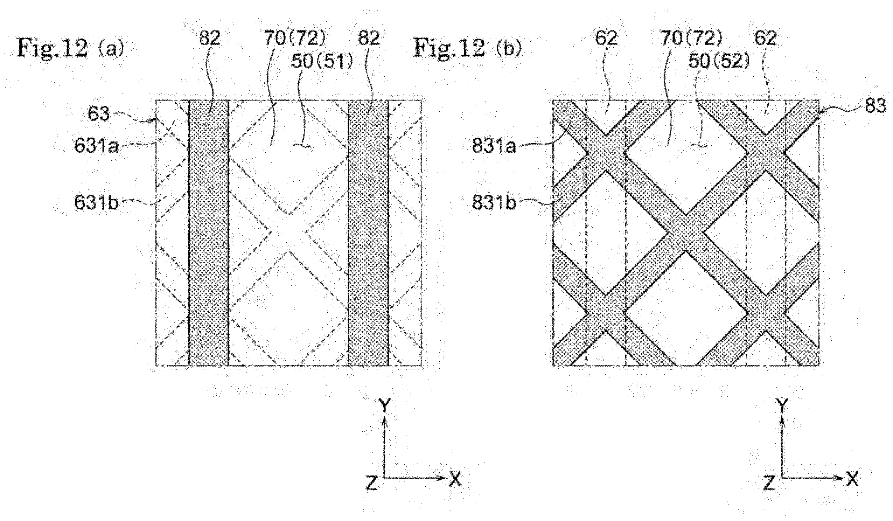

FIG. 1 is an exploded perspective view illustrating a touch sensor in an embodiment of the present invention, FIG. 2 is an exploded perspective view illustrating a wiring board in an embodiment of the present invention, FIG. 3 is a cross-sectional view along line III-III of FIG. 2, FIG. 4 is a partial cross-sectional view of a central portion along line IV-IV of FIG. 2, FIG. 5 is a plan view illustrating a first conductor layer in an embodiment of the present invention, FIG. 6 is an enlarged plan view illustrating a modified example of the first conductor layer in an embodiment of the present invention, FIG. 7 is a cross-sectional view illustrating a first electrode line in an embodiment of the present invention, FIG. 8 is a cross-sectional view for describing a first electrode line in an embodiment of the present invention, FIG. 9 is a plan view illustrating a second conductor layer in an embodiment of the present invention, FIG. 10 is a cross-sectional view illustrating a second electrode line in an embodiment of the present invention, FIG. 11 is a plan view illustrating a cover panel in an embodiment of the present invention, FIG. 12(a) is an enlarged plan view of part XIIa of FIG. 2, and FIG. 12(b) is an enlarged plan view of part XIIb of FIG. 2.

Touch sensor 1 in the present embodiment is, for example, a touch input device, such as used in a capacitance-type (mutual capacitance-type) touch panel or touch pad. As illustrated in FIG. 1, the touch sensor 1 comprises a housing 10, a wiring board 20 housed in the housing 10, an image display device 90 on which the wiring board 20 is laid, and a cover panel 110 that protects the wiring board 20.

In the touch sensor 1 comprising the wiring board 20, one of first and second electrodes 61 and 81 that are disposed to face each other is used as a detection-side electrode and the other is used as a drive-side electrode, and an external circuit (not illustrated) periodically applies a predetermined voltage between these two electrodes. For example, when the finger of an operator (external conductor) comes close to the touch sensor, a capacitor (capacitance) is formed between the external conductor and the touch sensor to change the electrical state between the two electrodes. The touch sensor can detect an operation position of the operator on the basis of the electrical change between the two electrodes.

The housing 10 is made of a metal material such as aluminum, a resin material such as polycarbonate (PC) and ABS resin, or other appropriate material.

As illustrated in FIG. 2, the wiring board 20 in the present embodiment comprises a first substrate 30A and a wiring body 40. As illustrated in FIG. 3 and FIG. 4, the wiring body 40 comprises a first resin layer 50, a first conductor layer 60, a second resin layer 70, and a second conductor layer 80. In the wiring body 40 of the present embodiment, the first resin layer 50, first conductor layer 60, second resin layer 70, and second conductor layer 80 are laid on each other in this order from below (the image display device 90 side) toward above (the cover panel 110 side) in FIG. 3 and FIG. 4. The "wiring board 20" in the present embodiment corresponds to an example of the "wiring board" in the present invention, and the "wiring body 40" in the present embodiment corresponds to an example of the "wiring body" in the present invention.

The first substrate 30A has a rectangular shape as illustrated in FIG. 2 to FIG. 4 and is composed of a film of polyethylene terephthalate (PET). The material which constitutes the first substrate 30A is not particularly limited to the above. Examples of the material include polyethylene naphthalate (PEN), polyimide resin (PI), polyetherimide resin (PEI), polycarbonate (PC), polyether ether ketone (PEEK), liquid-crystal polymer (LCP), cycloolefin polymer (COP), silicone resin (SI), acrylic resin, phenol resin, epoxy resin, green sheet, and glass. Such a base material may be formed with an easy-adhesion layer and/or an optical adjustment layer. The shape of the first substrate 30A is not particularly limited. When the wiring board 20 of the present embodiment is used in a touch panel, the first substrate 30A is made of a material having optical transparency. In this case, the total light transmittance of the material which constitutes the first substrate 30A is preferably 80% or higher and more preferably 90% or higher. The "first substrate 30A" in the present embodiment corresponds to an example of the "support body" in the present invention.

The first resin layer 50 is a layer that adheres to the first substrate 30A and the first conductor layer 60 to fix them to each other. As illustrated in FIG. 3 and FIG. 4, the first resin layer 50 is provided on the entire area of a main surface 31A of the first substrate 30A. Examples of a material that constitutes the first resin layer 50 include a UV-curable resin, a thermoset resin, and a thermoplastic resin, such as an epoxy resin, acrylic resin, polyester resin, urethane resin, vinyl resin, silicone resin, phenol resin, and polyimide resin. When the wiring board 20 of the present embodiment is used in a touch panel, the first resin layer 50 is made of a material having optical transparency. In this case, the total light transmittance of the material which constitutes the first resin layer 50 is preferably 80% or higher and more preferably 90% or higher.

The first resin layer 50 has protrusions 51 that support the first conductor layer 60, and a main part 52 that is provided between the protrusions 51 and the main surface 31A of the first substrate 30A to cover the main surface 31A. The protrusions 51 and the main part 52 are formed integrally.

Cross-sectional shapes (cross-sections in the transverse direction) of the protrusions 51 in the present embodiment are shapes that narrow toward a direction departing from the first substrate 30A (upper direction in FIG. 3). Boundaries between the protrusions 51 and the first conductor layer 60 are in uneven (irregular) shapes that correspond to uneven shapes of lower surfaces of the first conductor layer 60 (lower surfaces 613, 621, and 632 of conductor lines 612, 62, and 631 (which will be described later)). Such uneven shapes are formed due to the surface roughness of the lower surfaces 613, 621, and 632 of the conductor lines 612, 62, and 631. Although not particularly illustrated, boundaries between the protrusions 51 and the conductor lines 612, 62, and 631 in cross-sections along extending directions of the conductor lines 612, 62, and 631 are also in uneven shapes that correspond to the uneven shapes of the lower surfaces 613, 621, and 632 of the conductor lines 612, 62, and 631. The surface roughness of the lower surfaces 613, 621, and 632 will be described later in detail. For easy understanding of the wiring body 40 in the present embodiment, FIG. 3 and FIG. 4 illustrate the uneven shapes of boundaries between the protrusions 51 and the conductor lines 612, 62, and 631 in an exaggerated manner.

The main part 52 is provided on the entire area of the main surface 31A of the first substrate 30A at its approximately uniform height (thickness). Providing the protrusions 51 on the main part 52 allows the first resin layer 50 to protrude at the protrusions 51. The height (thickness) of the first resin layer 50 is preferably 5 $\mu$m to 100 $\mu$m at the main part 52. The "first resin layer 50" in the present embodiment corresponds to an example of the "second insulation layer" and the "third insulation layer" in the present invention.

The first conductor layer 60 of the present embodiment is made of a conductive powder and a binder. Specific examples of a material of the conductive powder include a metal material, such as silver, copper, nickel, tin, bismuth, zinc, indium, and palladium; and a carbon-based material, such as graphite, carbon black (furnace black, acetylene black, Ketjen black), carbon nanotube, and carbon nanofiber. Metal salts that are salts of the above metals may also be used, other than the conductive powder.

Conductive powder that can be used as the conductive powder included in the first conductor layer 60 may have, for example, a diameter $\varphi$ of 0.5 $\mu$m to 2 $\mu$m (0.5 $\mu m \leq \varphi \leq 2$ $\mu$m) in accordance with the widths of conductor lines 612, 62, and 631 to be formed (which will be described later). From the viewpoint of stabilizing the electric resistance value of the first conductor layer 60, it is preferred to use conductive powder having an average diameter $\varphi$ that is not larger than half the width of a conductor pattern to be formed. It may be preferred to use particles of which the specific surface area as measured by a BET method is 20 $m^2/g$ or more, as the conductive powder.

When the first conductor layer 60 is required to have a relatively small electric resistance value that is not larger than a certain level, it is preferred to use a metal material as the conductive material, while when the first conductor layer 60 is accepted to have a relatively large electric resistance value that is not smaller than a certain level, a carbon-based material can be used as the conductive material. From the viewpoint of improving the haze and total light reflectance of a mesh film, it is preferred to use a carbon-based material.

In the present embodiment, first electrodes 61 are formed into a mesh-like shape to give optical transparency. In this case, conductive materials that are excellent in the conductivity but opaque, such as silver, copper, nickel and other metal materials and the above-described carbon-based materials, (opaque metal materials and opaque carbon-based materials) can be used as a constitutional material of the first electrodes 61.

Specific examples of the binder include acrylic resin, polyester resin, epoxy resin, vinyl resin, urethane resin, phenol resin, polyimide resin, silicone resin, and fluorine resin.

The first conductor layer 60 as the above may be formed by applying a conductive paste and curing it. Specific examples of such a conductive paste include a conductive paste that is composed by mixing the above-described conductive powder and binder with water or solvent and various additives. Examples of the solvent contained in the conductive paste include $\alpha$-terpineol, butyl carbitol acetate, butyl carbitol, 1-decanol, butyl cellosolve, diethylene glycol monoethyl ether acetate, and tetradecane. The first conductor layer 60 of the present embodiment is composed of the conductive powder and the binder, but the present invention is not limited to this. In an alternative embodiment, the binder may be omitted.

As illustrated in FIG. 5, the first conductor layer 60 of the present embodiment comprises first electrodes 61, first lead wires 62, first shield layers 63, electrode connection parts 64, first terminals 65, a conduction wire 66, and a terminal 67 for shield layers. The "first conductor layer 60" in the present embodiment corresponds to an example of the first conductor layer in the present invention.

The first electrodes 61 are drive-side electrodes (transmission-side electrodes) to which a power source (not illustrated) applies a predetermined pulse voltage via the first lead wires 62. The first electrodes 61 are formed at locations corresponding to a display part 91 (which will be described later) of the image display device 90 and arranged to overlap the display part 91 in the plan view. The first electrodes 61 are composed of three first electrode patterns 611 that extend along the Y-axis direction. The first electrode patterns 611 are electrically insulated from one another, and the space between adjacent first electrode patterns 611 is approximately the same. In the touch sensor 1 of the present embodiment, a drive circuit performs control such that a pulse voltage is in turn applied to the first electrode patterns 611 in a time-division manner. The number and arrangement of the first electrode patterns 611 included in the first electrodes 61 are not particularly limited to the above.

Each of the first electrode patterns 611 is configured such that a plurality of first electrode lines 612a and 612b having conductivity intersects with one another, and has a mesh-like shape as a whole in which squares are repeated.

Specifically, each first electrode line 612a extends linearly along a direction inclined by 45° with respect to the X-direction (this direction will be also simply referred to as a "first direction," hereinafter), and the plurality of the first electrode lines 612a is arranged at a regular pitch in a direction that is substantially orthogonal to the first direction (this direction will be also simply referred to as a "second direction," hereinafter). On the other hand, each first electrode line 612b extends linearly along the second direction, and the plurality of the first electrode lines 612b is arranged at a regular pitch in the first direction. The first electrode lines 612a and 612b are orthogonal to one another, and the first electrode patterns 611 are thereby formed in which unit meshes of square shapes are repeated.

Such a mesh-like shape as in the present embodiment allows the first electrode patterns 611 to be formed together with the first lead wires 62 and the electrode connection parts 64. It is thus possible to simplify the production process for the wiring body 40 (wiring board 20) and reduce the production cost of the wiring body 40 (wiring board 20). Moreover, the quality of the wiring body 40 (wiring board 20) comprising the first electrode patterns 611 of the present embodiment can be improved as compared with cases of using indium tin oxide (ITO) or conductive polymer as the material for electrode patterns. This will be specifically described. When a wiring body is used in a touch panel, an image display device on which the wiring body is laid has to be visible from the wiring body side. To this end, transparent ITO or conductive polymer can be used as the material which constitutes the electrode patterns (in this case, the electrode patterns may be solid patterns). However, ITO or conductive polymer have a problem in that the electric resistance value increases during a baking process for the electrode patterns. In contrast, when conductive powder (material without transparency) is used as the material which constitutes the electrode patterns as in the present embodiment, the electrode patterns are formed into a mesh-like shape thereby to suppress increase of the electric resistance value during the baking of the electrode patterns while ensuring the visibility of the image display device. In other words, according to the first electrode patterns 611 formed into mesh-like patterns using conductive powder, the electric resistance value is suppressed at a low value, the sensitivity of the touch panel is enhanced, and accordingly the quality of the wiring body 40 (wiring board 20) is improved, as compared with the cases of using ITO or conductive polymer as the material for electrode patterns.

The structure of the first electrode patterns 611 formed into a mesh-like shape is not particularly limited to the above. For example, the pitch of the first electrode lines 612a is substantially the same as the pitch of the first electrode lines 612b in the present embodiment, but the present invention is not limited to this, and the pitch of the first electrode lines 612a may be different from the pitch of the first electrode lines 612b. The first direction is a direction inclined by 45° with respect to the X-direction in the present embodiment, but the present invention is not limited to this, and the first direction may be inclined by an angle other than 45° with respect to the X-direction. The same applies to the second direction.

The shape of the first electrode patterns 611 is also not particularly limited to the above and may have a certain geometrical pattern. That is, the shape of unit meshes of the first electrode patterns 611 may be a triangle, such as a regular triangle, isosceles triangle and right triangle, and may also be a quadrangle, such as a rectangle, square, rhombus, parallelogram and trapezoid. The shape of unit meshes may also be an n-polygon, such as a hexagon, octagon, dodecagon and icosagon, circle, ellipsoid, and star-shape. Thus, in the first electrode patterns 611, a geometrical pattern obtained by repeating any of various figure units can be used as the shape of unit meshes of the first electrode patterns 611. In the present embodiment, the first electrode lines 612a and 612b are in a straight line-like form, but the present invention is not limited to this, and they may be in a specific form, such as a curved form, horseshoe-like form and zigzag form.

The width of the first electrode lines 612a and 612b which constitute the first electrode patterns 611 is preferably 1 μm to 5 μm. The height of the first electrode lines 612a and 612b is preferably 0.5 μm to 10 μm. The pitch between adjacent first electrode lines 612a and 612a is preferably 30 μm to 1000 μm. The pitch between adjacent first electrode lines 612b and 612b is preferably 30 μm to 1000 μm. The angle (acute angle side) formed between each of the first electrode lines 612a and 612b and the X-direction is preferably 30° to 60°.

Although not particularly illustrated, the first electrode patterns 611 may each have a frame part that surrounds at least a part of the mesh shape formed by the first electrode lines 612a and 612b. In the following description, the first electrode lines 612a and 612b will be collectively referred to as "first electrode lines 612" as necessary. The "first electrodes 61" in the present embodiment correspond to an example of the "first electrode" in the present invention.

The first lead wires 62 are made of the same material as the material which constitutes the first electrodes 61. The first lead wires 62 are formed substantially on the same plane as the first electrodes 61. While, as described above, the first electrodes 61 of the present embodiment are arranged to overlap the display part 91 of the image display device 90 in the plan view, the first lead wires 62 are formed within a region that excludes the region overlapping the display part 91 of the image display device 90 in the plan view.

The first lead wires 62 are formed to correspond to the first electrode patterns 611. In the present embodiment, three first lead wires 62 are formed to correspond to the formation of the three first electrode patterns 611. Each of the first lead wires 62 is a wire having a portion that extends along the X-direction, portions that extend along the Y-direction, and curved parts that are curved at their intersecting portions. The first lead wires 62 are formed to be separated and thus electrically insulated from one another.

One ends of the first lead wires 62 are connected to the electrode connection parts 64, and the other ends are connected to the first terminals 65. The electrode connection parts 64 are portions that connect between the first electrodes 61 and the first lead wires 62, and have approximately the same width as that of the first electrodes 61. The first terminals 65 are exposed from the second resin layer 70 which covers the first conductor layer 60, and the first lead wires 62 can thereby be connected to an external circuit via the first terminals 65.

The width of such first lead wires 62 is preferably 10 μm to 100 μm. The height of the first lead wires 62 is preferably 0.5 μm to 20 μm.

The first lead wires 62, the electrode connection parts 64, and the first terminals 65 may be formed in a mesh-like shape with a plurality of narrow lines that intersect with one another (see FIG. 6). In this case, the first lead wires 62 are composed of first and second narrow lines 624a and 624b that extend in different directions, the plurality of first narrow lines 624a extending in the first direction is arranged at a regular pitch $P_1$ in the second direction, and the plurality of second narrow lines 624b extending in the second direction is arranged at the regular pitch $P_1$ in the first direction. Similarly, the electrode connection parts 64 are composed of first and second narrow lines 641a and 641b that extend in different directions, the plurality of first narrow lines 641a extending in the first direction is arranged at a regular pitch $P_2$ in the second direction, and the plurality of second narrow lines 641b extending in the second direction is arranged at the regular pitch $P_2$ in the first direction.

When the first lead wires 62 and the electrode connection parts 64 are formed in mesh-like shapes as the above, a width $L_1$ of the first and second narrow lines 624a and 624b which constitute the first lead wires 62 and a width $L_2$ of the first and second narrow lines 641 a and 641b which constitute the electrode connection parts 64 are preferably line widths that are not smaller than a width $L_3$ of the first electrode lines 612a and 612b which constitute the first electrode patterns 611 ($L_1$, $L_2 \geq L_3$). The pitch $P_1$ of narrow lines in the first lead wires 62 and the pitch $P_2$ of narrow lines in the electrode connection parts 64 are preferably pitches that are not larger than a pitch $P_3$ of narrow lines in the first electrode patterns 611 ($P_1$, $P_2 \leq P_3$). Although not particularly illustrated, also in the first terminals 65, similarly to the first lead wires 62 and the electrode connection parts 64, the width of narrow lines which constitute the first terminals 65 is preferably a line width that is not smaller than the width of narrow lines in the first electrode patterns 611, and the pitch of narrow lines which constitute the first terminals 65 is preferably a pitch that is not larger than the pitch of narrow lines in the first electrode patterns 611.

Specifically, when the first lead wires 62 are formed in a mesh-like shape, the width $L_1$ of the first and second narrow lines 624a and 624b is preferably 5 μm to 20 μm. The height of the first and second narrow lines 624a and 624b is preferably 0.5 μm to 20 μm. The pitch $P_1$ between adjacent first narrow lines 624a and 624a (between adjacent second narrow lines 624b and 624b) is preferably 10 μm to 40 μm. The angle (acute angle side) formed between each of the first and second narrow lines 624a and 624b and the X-direction is preferably 15° to 60°.

When the electrode connection parts 64 are formed in a mesh-like shape, the width $L_2$ of the first and second narrow lines 641a and 641b is preferably 5 μm to 20 μm. The height of the first and second narrow lines 641a and 641b is preferably 0.5 μm to 20 μm. The pitch $P_2$ between adjacent first narrow lines 641a and 641a (between adjacent second narrow lines 641b and 641b) is preferably 10 μm to 100 μm. The angle (acute angle side) formed between each of the first and second narrow lines 641a and 641b and the X-direction is preferably 15° to 75°.

The width $L_1$ of the first and second narrow lines 624a and 624b is preferably 1 to 20 times the width $L_3$ of the first electrode lines 612a and 612b. The width $L_2$ of the first and second narrow lines 641a and 641b is preferably 1 to 20 times the width $L_3$ of the first electrode lines 612a and 612b. The pitch $P_1$ between adjacent first narrow lines 624a and 624a (between adjacent second narrow lines 624b and 624b) is preferably 0.01 to 1 times the pitch $P_3$ between adjacent first electrode lines 612a and 612a (between adjacent first electrode lines 612b and 612b). The pitch $P_2$ between adjacent first narrow lines 641a and 641a (between adjacent second narrow lines 641b and 641b) is preferably 0.01 to 1 times the pitch $P_3$ between adjacent first electrode lines 612a and 612a (between adjacent first electrode lines 612b and 612b).

The first electrode patterns 611 are connected to the first lead wires 62 via the electrode connection parts 64 in the present embodiment, but the present invention is not limited to this, and the first electrode patterns 611 may be connected to the first lead wires 62 without via electrode connection parts 64. The "first lead wires 62" in the present embodiment correspond to an example of the "first lead wire" in the present invention and the "first terminals 65" in the present embodiment correspond to an example of the "first terminal" in the present invention.

Referring again to FIG. 5, the first shield layers 63 are conductive layers made of the same material as the material which constitutes the first electrodes 61 and are shield layers that electromagnetically shield second lead wires 82 (which will be described later) of the second conductor layer 80. The first shield layers 63 are formed substantially on the same plane as the first electrodes 61 and the first lead wires 62. The first shield layers 63 are provided so as to be electrically insulated from the first electrodes 61 and the first lead wires 62. The first shield layers 63, like the above-described first lead wires 62, are formed within a region that excludes the region overlapping the display part 91 of the image display device 90 in the plan view.

The first shield layers 63 of the present embodiment are formed as two divided parts in the plan view. These first shield layers 63 are electrically connected to each other via the conduction wire 66. One of the first shield layers 63 is connected to the terminal 67 for shield layers. The terminal 67 for shield layers is exposed from the second resin layer 70 which covers the first conductor layer 60. The first shield layers 63 can thus be connected to an external circuit (not illustrated) via the terminal 67 for shield layers. The external circuit connected to the terminal 67 for shield layers is grounded, and the first shield layers 63 are connected to the external circuit thereby to be also grounded.

Each of the first shield layers 63 of the present embodiment is configured such that a plurality of first shield lines 631a and 631b having conductivity intersects with one another, and has a mesh-like shape as a whole in which squares are repeated.

Specifically, each first shield line 631a extends linearly along a direction inclined by 45° with respect to the X-direction (this direction will be also simply referred to as a "third direction," hereinafter), and the plurality of the first shield lines 631a is arranged at a regular pitch in a direction that is substantially orthogonal to the third direction (this direction will be also simply referred to as a "fourth direction," hereinafter). On the other hand, each first shield line 631b extends linearly along the fourth direction, and the plurality of the first shield lines 631b is arranged at a regular pitch in the third direction. The first shield lines 631a and 631b are orthogonal to one another, and the first shield layers 63 are thereby formed in which unit meshes of square shapes are repeated.

The structure of the first shield layers 63 formed into a mesh-like shape is not particularly limited to the above. For example, the pitch of the first shield lines 631a is substantially the same as the pitch of the first shield lines 631b in the present embodiment, but the present invention is not limited to this, and the pitch of the first shield lines 631a may be different from the pitch of the first shield lines 631b. The third direction is a direction inclined by 45° with respect to the X-direction in the present embodiment, but the present invention is not limited to this, and the third direction may be inclined by an angle other than 45° with respect to the X-direction. The same applies to the fourth direction.

In the present embodiment, by providing a large pitch of the first shield lines 631a and 631b or by providing a narrow width of the first shield lines 631a and 631b, it is possible to suppress deterioration of the flexibility of the wiring board 20 (wiring body 40) comprising the first shield lines 631a and 631b. In an alternative embodiment, by providing a small pitch of the first shield lines 631a and 631b or by providing a wide width of the first shield lines 631a and 631b, it is possible to improve the shield property of the first shield layers 63 for the second lead wires 82.

The shape of the first shield layers 63 is also not particularly limited to the above and may have a certain geometrical pattern. That is, the shape of unit meshes of the first shield layers 63 may be a triangle, such as a regular triangle, isosceles triangle and right triangle, and may also be a quadrangle, such as a rectangle, square, rhombus, parallelogram and trapezoid. The shape of unit meshes may also be an n-polygon, such as a hexagon, octagon, dodecagon and icosagon, circle, ellipsoid, and star-shape. Thus, in the first shield layers 63, a geometrical pattern obtained by repeating any of various figure units can be used as the shape of unit meshes of the first shield layers 63. In the present embodiment, the first shield lines 631a and 631b are in a straight line like form, but the present invention is not limited to this, and they may be in a specific form, such as a curved form, horseshoe-like form and zigzag form.

The width of such first shield lines 631a and 631b is preferably 5 μm to 20 μm. The height of the first shield lines 631a and 631b is preferably 0.5 μm to 20 μm. The pitch between adjacent first shield lines 631a and 631a (between adjacent first shield lines 631b and 631b) is preferably 10 μm to 1000 μm. The angle (acute angle side) formed between each of the first shield lines 631a and 631b and the X-direction is preferably 30° to 55°.

The width of the first shield lines 631a and 631b is preferably 1 to 20 times the width $L_3$ of the first electrode lines 612a and 612b. The pitch between adjacent first shield lines 631a and 631a (between adjacent first shield lines 631b and 631b) is preferably 2 to 1000 times the pitch $P_3$ between adjacent first electrode lines 612a and 612a (between adjacent first electrode lines 612b and 612b).

The conduction wire 66 may also have a mesh-like shape (not illustrated) corresponding to the mesh-like shape of the first shield layers 63. In this case, by providing a large pitch of narrow lines in the conduction wire 66 or by providing a narrow width of the narrow lines which constitute the conduction wire 66, it is possible to suppress deterioration of the flexibility of the wiring board 20 (wiring body 40). In an alternative embodiment, by providing a small pitch of the narrow lines in the conduction wire 66 or by providing a wide width of the narrow lines which constitute the conduction wire 66, it is possible to improve the shield property of the first shield layers 63 for the second lead wires 82.

In the following description, the first shield lines 631a and 631b will be collectively referred to as first shield lines 631 as necessary, and the first electrode lines 612, the first lead wires 62 and the first shield lines 631 will be collectively referred to as conductor lines 612, 62, and 631. The "first shield layers 63" in the present embodiment correspond to an example of the "first shield layer" in the present invention.

Referring again to FIG. 3 and FIG. 4, each of side surfaces 615, 623, and 634 of the conductor lines 612, 62, and 631 which constitute the first conductor layer 60 merges into a side part of the protrusions 51 of the first resin layer 50, which are in contact with the conductor lines 612, 62, and 631, to form one flat surface. The conductor lines 612, 62, and 631 have tapered shapes that narrow toward the second conductor layer 80 side (+Z-direction in the figures), so that the cross-sectional shapes (cross-sectional shapes in the transverse directions) of the conductor lines 612, 62, and 631 are approximately trapezoidal shapes. The cross-sectional shapes of the conductor lines 612, 62, and 631 are not particularly limited to the above. For example, the cross-sectional shapes of the conductor lines 612, 62, and 631 may be other shapes, such as square shapes, rectangular shapes, and triangular shapes.

The conductor lines 612, 62, and 631 of the present embodiment are embedded in the second resin layer 70, and their outer circumferential surfaces (upper surfaces 614, 622, and 633 and side surfaces 615, 623, and 634) are in direct contact with the second resin layer 70, but only lower surfaces 613, 621, and 632 of the conductor lines 612, 62, and 631 are not embedded in the second resin layer 70 and in direct contact with the first resin layer 50. That is, the upper surfaces 614, 622, and 633 and side surfaces 615, 623, and 634 of the conductor lines 612, 62, and 631 are contact surfaces that are in contact with the second resin layer 70, but the lower surfaces 613, 621, and 632 of the conductor lines 612, 62, and 631 are noncontact surfaces that are not in contact with the second resin layer 70. The "lower surfaces 613, 621, and 632" in the present embodiment correspond to an example of the "noncontact surface" in the present invention.

Outer shapes of the conductor lines 612, 62, and 631 of the present embodiment will be described below in detail with reference to FIG. 7 by exemplifying a first electrode line 612. As will be understood, the first lead wires 62 and the first shield lines 631 have the same basic structures as that of the first electrode line 612. FIG. 7 therefore illustrates only the first electrode line 612, and the corresponding reference numerals for the first lead wires 62 and the first shield lines 631 are parenthesized. Thus, the description for the first electrode line 612 will be borrowed herein to omit repetitive description.

The upper surface 614 of the first electrode line 612 is located at the opposite side to the lower surface 613 in the first electrode line 612. The upper surface 614 is substantially parallel to the main surface 31A of the first substrate 30A (upper surface of the main part 52 of the first resin layer 50).

The upper surface 614 includes a flat part 6141 in the cross-section of the first electrode line 612 in its width direction. The flat part 6141 is a straight line-like portion (i.e. portion with a considerably large radius of curvature) that exists on the upper surface 614 in the cross-section of the first electrode line 612 in its width direction, and the flatness of the flat part 6141 is 0.5 μm or less. The flatness is defined by a JIS method (JIS B0621 (1984)).

In the present embodiment, the flatness of the flat part 6141 is obtained using a contactless-type measurement method with laser light. Specifically, a measuring object (the upper surface upper surface 614 in the present embodiment) is irradiated with strip-like laser light, and the reflected light is focused on an imaging element (e.g. two-dimensional CMOS) to measure the flatness. The method of calculating the flatness may be a method that includes setting flat surfaces on an object surface so as to pass through three points separate from one another as much as possible and calculating the maximum value of deviation as the flatness (maximum deviation-type flatness). The methods of measuring and calculating the flatness are not limited to the above. For example, the method of measuring the flatness may be a contact-type measurement method using a dial gauge or other appropriate gauge. The method of calculating the flatness may also be a method that includes interposing an object surface between parallel flat surfaces and calculating a value of space generated due to the interposition as the flatness (maximum slope-type flatness).

The flat part 6141 of the present embodiment is formed at approximately the entire area of the upper surface 614. The location at which the flat part 6141 is formed is not particularly limited to the above, and the flat part 6141 may be formed at a part of the upper surface 614. In this case, for example, the flat part may be formed at a region that does not include both ends of the upper surface. When the flat part is formed at a part of the upper surface, the width of the flat part may be at least 1/2 or more of the width of the upper surface.

Each side surface 615 is located between the upper surface 614 and the lower surface 613. The side part 615 connects to the upper surface 614 at a first portion 6151 and connects to the lower surface 613 at a second portion 6152. The first electrode line 612 of the present embodiment has a tapered shape that narrows toward the second conductor layer 80 side. The second portion 6152 is therefore located outside the first portion 6151 in the cross-section of the first electrode line 612 in its width direction. In the cross-section of the first electrode line 612 in its width direction, the side surface 615 of the present embodiment represents a surface that extends on a virtual straight line (not illustrated) passing through the first and second portions 6151 and 6152.

The shape of the side surface 615 is not particularly limited to the above. For example, the side surface 615 may be in an arc shape that protrudes outward in the cross-section of the first electrode line 612 in its width direction. In this case, the side surface 615 exists outside the virtual straight line passing through the first and second portions 6151 and 6152. In other words, the shape of the side surface 615 may preferably be a shape in which a part of the side surface 615 does not exist inside the virtual straight line passing through the first and second portions 6151 and 6152, in the cross-section of the first electrode line 612 in its width direction. For example, when the outer shape (width) of the first electrode line 612 gradually becomes larger as approaching the first resin layer 50 in the cross-section of the first electrode line 612 in its width direction, if the side surface 615 is in an arc shape that protrudes inward (i.e., if the first electrode line 612 is in a divergent shape with its spread bottom), the light incident to the wiring body may readily undergo diffuse reflection.

The side surface 615 of the present embodiment includes a flat part 6153 in the cross-section of the first electrode line 612 in its width direction. The flat part 6153 is a straight line-like portion (i.e. portion with a considerably large radius of curvature) that exists on the side surface 615 in the cross-section of the first electrode line 612 in its width direction, and the flatness of the flat part 6153 is 0.5 μm or less. The flatness of the flat part 6153 can be measured in the same manner as in the method of measuring the flatness of the flat part 6141. In the present embodiment, the flat part 6153 is formed at approximately the entire area of the side surface 615. The shape of the flat part 6153 is not particularly limited to the above, and the flat part 6153 may be formed at a part of the side surface 615.

From the viewpoint of suppressing the diffuse reflection of light at the side surface 615, an angle $\theta_1$ between the side surface 615 and the upper surface 614 is preferably 90° to 170° ($90° \leq \theta_1 \leq 170°$) and more preferably 90° to 120° ($90° \leq \theta_1 \leq 120°$). In the present embodiment, in one first electrode line 612, the angle between one side surface 615 and the upper surface 614 is substantially the same as the angle between the other side surface 615 and the upper surface 614. In one first electrode line 612, the angle between one side surface 615 and the upper surface 614 may be different from the angle between the other side surface 615 and the upper surface 614.

The surface roughness of the lower surface 613 of the first electrode line 612 in the present embodiment is preferably relatively rougher than the surface roughness of the upper surface 614 of the first electrode line 612. Since the upper surface 614 includes the flat surface 6141 in the present embodiment, the above relative relationship of the surface roughness in the first electrode line 612 (relationship that the surface roughness of the lower surface 613 is relatively rougher than the surface roughness of the upper surface 614) is established. This can increase the contact area between the first conductor layer 60 (specifically the first electrode line 612) and the first resin layer 50 and tightly fix the first conductor layer 60 to the first resin layer 50.

Specifically, the surface roughness Ra of the lower surface 613 of the first electrode line 612 is preferably about 0.1 μm to 3 μm while the surface roughness Ra of the upper surface 614 is preferably about 0.001 μm to 1.0 μm. The surface roughness Ra of the lower surface 613 of the first electrode line 612 is more preferably 0.1 μm to 0.5 μm, and the surface roughness Ra of the upper surface 614 is furthermore preferably 0.001 μm to 0.3 μm. The ratio of the surface roughness of the upper surface 614 and the surface roughness of the lower surface 613 (ratio of the surface roughness of the upper surface 614 to the surface roughness of the lower surface 613) is preferably 0.01 or more and less than 1 and more preferably 0.1 or more and less than 1. The surface roughness of the upper surface 614 is preferably 1/5 or less of the width (maximum width) of the first electrode line 612. Such surface roughness can be measured in accordance with a JIS method (JIS B0601 (revised on March 21, 2013)). Measurement of the surface roughness of the upper surface 614 and the lower surface 613 may be performed along the width direction of the first electrode line 612 and may also be performed along the extending direction of the first electrode line 612.

As used herein, the "surface roughness Ra" refers to "arithmetic average roughness Ra" as described in the JIS method (JIS B0601 (revised on March 21, 2013)). The "arithmetic average roughness Ra" represents a roughness parameter that is obtained by shutting off long-wavelength components (waviness components) from a profile curve. Separation of the waviness components from the profile curve may be performed on the basis of the measurement condition which is necessary for obtaining a form (such as the size of an object, for example).

In the present embodiment, the side surface 615 includes the flat part 6153. The surface roughness of the lower surface 613 is therefore relatively rougher than that of the side surface 615. Specifically, the surface roughness Ra of the lower surface 613 of the first electrode line 612 is preferably 0.1 $\mu$m to 3 $\mu$m while the surface roughness Ra of the side surface 615 is preferably 0.001 $\mu$m to 1.0 $\mu$m and more preferably 0.001 $\mu$m to 0.3 $\mu$m. Measurement of the surface roughness of the side surface 615 may be performed along the width direction of the first electrode line 612 and may also be performed along the extending direction of the first electrode line 612.

In the present embodiment, the surface roughness of the lower surface 613 is relatively rougher than the surface roughness of the upper surface 614 and side surfaces 615 and, therefore, the diffuse reflectance of the wiring body 40 at other surfaces than the lower surface 613 (i.e. at the upper surface 614 and side surfaces 615) is relatively smaller than the diffuse reflectance of the wiring body 40 at the lower surface 613. From the viewpoint of improving the visibility of the wiring body 40, the ratio of the diffuse reflectance of the wiring body 40 at other surfaces than the lower surface 613 and the diffuse reflectance of the wiring body 40 at the lower surface 613 (ratio of the diffuse reflectance of the wiring body 40 at other surfaces than the lower surface 613 to the diffuse reflectance of the wiring body 40 at the lower surface 613) is preferably 0.1 or more and less than 1 and more preferably 0.3 or more and less than 1.

An example of the shape of a first electrode line having the above-described relative relationship of the surface roughness between the lower surface and other surfaces than the lower surface will be described with reference to FIG. 8. As illustrated in FIG. 8, in a first electrode line 612B that is composed of conductive powder particles M and a binder resin B, a number of the conductive powder particles M are dispersed in the binder resin B. In a lower surface 613B of the first electrode line 612B, a part of the conductive powder particles M protrudes from the binder resin B in the cross-section in the width direction. The lower surface 613B therefore has an uneven shape. On the other hand, in an upper surface 614B and side surfaces 615B, the binder resin B gets into spaces between the conductive powder particles M, and the binder resin B covers the conductive powder particles M. Thus, the upper surface 614B includes a flat part 6141B, and the side surfaces 615B include flat parts 6153B. In the upper surface 614B and the side surfaces 615B, the conductive powder particles M are covered with the binder resin B, so that the electric insulation is improved between adjacent first electrode lines 612B and the occurrence of migration is suppressed.

In the form illustrated in FIG. 8, the lower surface 613B has an uneven shape while the upper surface 614B includes the flat part 6141B. The surface roughness of the lower surface 613B is therefore relatively rougher than the surface roughness of the upper surface 614B. Similarly, the side parts 615B include the flat parts 6153B. The surface roughness of the lower surface 613B is therefore relatively rougher than the surface roughness of the side surfaces 615B. Forms of the lower surface 613, upper surface 614, and side surfaces 615 of each first electrode line 612 are not particularly limited to the forms illustrated in FIG. 8.

The first electrode lines 612, the first lead wires 62, and the first shield lines 631 may have different widths. The first electrode lines 612, the first lead wires 62, and the first shield lines 631 may have different heights. The surface roughness of lower surfaces 613 of the first electrode lines 612, the surface roughness of lower surfaces 621 of the first lead wires 62, and the surface roughness of lower surfaces 632 of the first shield lines 631 may be the same or different. The surface roughness of upper surfaces 614 of the first electrode lines 612, the surface roughness of upper surfaces 622 of the first lead wires 62, and the surface roughness of upper surfaces 633 of the first shield lines 631 may be the same or different. In FIG. 3 and FIG. 4, the first electrode lines 612, the first lead wires 62, and the first shield lines 631 have similar shapes, but the present invention is not particularly limited to this. When the first lead wires 62 have a mesh-like shape, the basic structure of the first and second narrow lines 624a and 624b which constitute the first lead wires 62 is the same as the basic structure of the conductor lines 612, 62, and 631. Similarly, when the electrode connection parts 64 have a mesh-like shape, the basic structure of the first and second narrow lines 641a and 641b which constitute the electrode connection parts 64 is the same as the basic structure of the conductor lines 612, 62, and 631.

In the wiring body 40 of the present embodiment, it is preferred that the following Expression (2) be established:

$$0.5 \leq A_1 \ldots (2).$$

In the above Expression (2), $A_1$ is a maximum value of $C_1/B_1$, $B_1$ is a width of the first conductor layer 60 in the cross-sectional view in the transverse direction, and $C_1$ is a height of the first conductor layer 60 in the cross-sectional view in the transverse direction.

As used herein, the "width $B_1$ of the first conductor layer 60 in the cross-sectional view in the transverse direction" refers to each of widths of the conductor lines 612, 62, and 631 in their extending directions and, in the present embodiment, corresponds to each of widths of the lower surfaces 613, 621, and 632. The "height $C_1$ of the first conductor layer 60 in the cross-sectional view in the transverse direction" refers to each of heights (thicknesses) of the conductor lines 612, 62, and 631 having the width $B_1$ and, in the present embodiment, corresponds to each of distances between the lower surfaces 613, 621, and 632 and the upper surfaces 614, 622, and 633. The parameter $A_1$ in the present embodiment therefore refers to the maximum value of a ratio of the height $C_1$ to the width $B_1$ of each of the conductor lines 612, 62, and 631.

In the present embodiment, the above Expression (2) is preferably established in at least one of the first electrode lines 612, the first lead wires 62, and the first shield lines 631 and more preferably established in all of the first electrode lines 612, the first lead wires 62, and the first shield lines 631.

The second resin layer 70 in the present embodiment, which is interposed between the first and second conductor layers 60 and 80 as illustrated in FIG. 3 and FIG. 4, is composed of a material having insulation properties. Examples of such a material that constitutes the second resin layer 70 include a UV-curable resin, a thermoset resin, and a thermoplastic resin, such as an epoxy resin, acrylic resin, polyester resin, urethane resin, vinyl resin, silicone resin, phenol resin, and polyimide resin. When the wiring board 20 of the present embodiment is used in a touch panel, the second resin layer 70 is made of a material having optical transparency. In this case, the total light transmittance of the material which constitutes the second resin layer 70 is preferably 80% or higher and more preferably 90% or higher.

The second resin layer 70 has a main part 72 that has an approximately flat upper surface and protrusions 71 that are provided on the main part 72. The main part 72 covers the first resin layer 50 and the first conductor layer 60 (excluding the terminals 65 and 67). The protrusions 71 protrude toward the second conductor layer 80 side (+Z-direction in the figures) and have a formation pattern corresponding to the second conductor layer 80.

Cross-sectional shapes (cross-sectional shapes in the transverse direction) of the protrusions 71 in the present embodiment are shapes that narrow toward a direction departing from the first substrate 30A (+Z-direction in the figures). Boundaries between the protrusions 71 and the second conductor layer 80 are in uneven shapes that correspond to uneven shapes of lower surfaces of the second conductor layer 80 (lower surfaces 813, 821, and 832 of conductor lines 812, 82, and 831 (which will be described later)). Such uneven shapes are formed due to the surface roughness of the lower surfaces 813, 821, and 832 of the conductor lines 812, 82, and 831. Although not particularly illustrated, boundaries between the protrusions 71 and the conductor lines 812, 82, and 831 in cross-sections along extending directions of the conductor lines 812, 82, and 831 are also in uneven shapes that correspond to the uneven shapes of the lower surfaces 813, 821, and 832 of the conductor lines 812, 82, and 831. The surface roughness of the lower surfaces 813, 821, and 832 will be described later in detail. For easy understanding of the wiring body 40 for a touch sensor in the present embodiment, FIG. 3 and FIG. 4 illustrate the uneven shapes of boundaries between the protrusions 71 and the conductor lines 812, 82, and 831 in an exaggerated manner.

In the present embodiment, a minimum height (minimum thickness) $W_1$ of the second resin layer 70 at the main part 72 is larger than a maximum height (maximum thickness) $W_2$ of the first conductor layer 60. According to this relationship, insulation between the first and second conductor layers 60 and 80 can be ensured. The "second resin layer 70" in the present embodiment corresponds to an example of the "first insulation layer" in the present invention.

The second conductor layer 80 of the present embodiment is composed of a conductive powder and a binder. Specific examples of materials of the conductive powder and binder include those of the conductive powder and binder which constitute the first conductor layer 60. Also in the second conductor layer 80, the binder may be omitted as in the first conductor layer 60.

As illustrated in FIG. 3, the second conductor layer 80 of the present embodiment is provided on the second resin layer 70. As illustrated in FIG. 9, the second conductor layer 80 comprises second electrodes 81, second lead wires 82, a second shield layer 83, electrode connection parts 84, second terminals 85, and a terminal 86 for the shield layer.

The second electrodes 81 are detection-side electrodes (reception-side electrodes) that collect electrical charge corresponding to the pulse voltage applied to the first electrodes 61. The second electrodes 81 are formed at locations corresponding to the display part 91 of the image display device 90 and arranged to overlap the display part 91 in the plan view. The second electrodes 81 are composed of four second electrode patterns 811 that extend along the X-axis direction. The second electrode patterns 811 are electrically insulated from one another, and the space between adjacent second electrode patterns 811 is approximately the same. The number and arrangement of the second electrode patterns 811 included in the second electrodes 81 are not particularly limited to the above.

As illustrated in FIG. 9, each of the second electrode patterns 811 is configured such that a plurality of second electrode lines 812a and 812b having conductivity intersects with one another, and has a mesh-like shape as a whole in which squares are repeated.

Specifically, each second electrode line 812a extends linearly along the first direction like the first electrode line 612a, and the plurality of the second electrode lines 812a is arranged at a regular pitch in the second direction. On the other hand, each second electrode line 812b extends linearly along the second direction, and the plurality of the second electrode lines 812b is arranged at a regular pitch in the first direction. The second electrode lines 812a and 812b are orthogonal to one another, and the second electrode patterns 811 are thereby formed in which unit meshes of square shapes are repeated.

As in the case of the first electrode patterns 611, the second electrode patterns 811 can also be formed into a mesh-like shape thereby to simplify the production process for the wiring body 40 (wiring board 20) and reduce the production cost of the wiring body 40 (wiring board 20). Moreover, the quality of the wiring body 40 (wiring board 20) can be improved as compared with cases of using indium tin oxide (ITO) or conductive polymer as the material for electrode patterns.

The structure of the second electrode patterns 811 formed into a mesh-like shape is not particularly limited to the above. For example, the pitch of the second electrode lines 812a is substantially the same as the pitch of the second electrode lines 812b in the present embodiment, but the present invention is not limited to this, and the pitch of the second electrode lines 812a may be different from the pitch of the second electrode lines 812b. The second electrode lines 812a extend in a direction that is substantially parallel to the first electrode lines 612a and the second electrode lines 812b extend in a direction that is substantially parallel to the first electrode lines 612b in the present embodiment, but the present invention is not limited to this, and they may extend in different directions with respect to the first electrode lines 612a and 612b.

Also in the second electrode patterns 811, a geometrical pattern obtained by repeating any of various figure units can be used as the shape of unit meshes of the second electrode patterns 811 as in the first electrode patterns 611. In the present embodiment, the second electrode lines 812a and 812b are in a straight line-like form, but the present invention is not limited to this, and they may be in a specific form, such as a curved form, horseshoe-like form and zigzag form.

The width of such second electrode lines 812a and 812b is preferably 1 μm to 5 μm. The height of the second electrode lines 812a and 812b is preferably 0.5 μm to 10 μm. The pitch between adjacent second electrode lines 812a and 812a is preferably 30 μm to 1000 μm. The pitch between adjacent second electrode lines 812b and 812b is preferably 30 μm to 1000 μm. The angle (acute angle side) formed between each of the second electrode lines 812a and 812b and the X-direction is preferably 30° to 60°.

Although not particularly illustrated, the second electrode patterns 811 may each have a frame part that surrounds at least a part of the mesh shape formed by the second electrode lines 812a and 812b. In the following description, the second electrode lines 812a and 812b will be collectively referred to as "second electrode lines 812" as necessary. The "second electrodes 81" in the present embodiment correspond to an example of the "second electrode" in the present invention.

The second lead wires 82 are composed of the same material as the material which constitutes the second electrodes 81. The second lead wires 82 are formed substantially on the same plane as the second electrodes 81. While, as described above, the second electrodes 81 of the present embodiment are arranged to overlap the display part 91 of the image display device 90 in the plan view, the second lead wires 82 are formed within a region that excludes the region overlapping the display part 91 of the image display device 90 in the plan view.

The second lead wires 82 are formed to correspond to the second electrode patterns 811. In the present embodiment, four second lead wires 82 are formed to correspond to the formation of the four second electrode patterns 811. As found in FIG. 9, two second lead wires 82 are connected from the left-side (-X-direction side) to two second electrode patterns 811 located at the upper side in FIG. 9 while the remaining two second lead wires 82 are connected from the right-side (+X-direction side) to the remaining two second electrode patterns 811 located at the lower side in FIG. 9. Leading-out directions of the second lead wires 82 are distributed in this manner, and the width of a bezel portion (portion that does not overlap the display part 91 in the plan view) is thereby suppressed from excessively increasing.

Each of the second lead wires 82 is a wire having portions that extend along the X-direction, portions that extend along the Y-direction, and curved parts that are curved at their intersecting portions. The second lead wires 82 are formed to be separated and thus electrically insulated from one another.

One ends of the second lead wires 82 are connected to the electrode connection parts 84, and the other ends are connected to the second terminals 85. The electrode connection parts 84 are portions that connect between the second electrodes 81 and the second lead wires 82, and have approximately the same width as that of the second electrodes 81. The second terminals 85 connect the second lead wires 82 to an external circuit.

The width of such second lead wires 82 is preferably 10 μm to 100 μm. The height of the second lead wires 82 is preferably 0.5 μm to 20 μm.

The second lead wires 82, the electrode connection parts 84, and the second terminals 85 may be formed in a mesh-like shape with a plurality of narrow lines that intersect with one another. In this case, shapes of the second lead wires 82, the electrode connection parts 84, and the second terminals 85 may be different from those of the first lead wires 62, the electrode connection parts 64, and the first terminals 65 to some extent, but the basic structure is the same. FIG. 6 therefore illustrates the first lead wire 62, the electrode connection part 64, and the first terminal 65, and the description of the second lead wires 82, the electrode connection parts 84, and the second terminals 85 will be omitted by denoting the corresponding reference numerals in parentheses.

When the second lead wires 82 and the electrode connection parts 84 are formed in a mesh-like shape as the above, a width $L_4$ of the first and second narrow lines 824a and 824b which constitute the second lead wires 82 and a width $L_5$ of the first and second narrow lines 841a and 841b which constitute the electrode connection parts 84 are preferably line widths that are not smaller than a width $L_6$ of the second electrode lines 812a and 812b which constitute the second electrode patterns 811 ($L_4, L_5 \geq L_6$). The pitch $P_4$ of narrow lines in the second lead wires 82 and the pitch $P_5$ of narrow lines in the electrode connection parts 84 are preferably pitches that are not larger than a pitch $P_6$ of narrow lines in the second electrode patterns 811 ($P_4, P_5 \leq P_6$). Although not particularly illustrated, also in the second terminals 85, similarly to the second lead wires 82 and the electrode connection parts 84, the width of narrow lines which constitute the second terminals 85 is preferably a line width that is not smaller than the width of narrow lines in the second electrode patterns 811, and the pitch of narrow lines which constitute the second terminals 85 is preferably a pitch that is not larger than the pitch of narrow lines in the second electrode patterns 811.

When the second lead wires 82 are formed in a mesh-like shape, the width $L_4$ of the first and second narrow lines 824a and 824b is preferably 5 μm to 20 μm. The height of the first and second narrow lines 824a and 824b is preferably 0.5 μm to 20 μm. The pitch $P_4$ between adjacent first narrow lines 824a and 824a (between adjacent second narrow lines 824b and 824b) is preferably 10 μm to 40 μm. The angle (acute angle side) formed between each of the first and second narrow lines 824a and 824b and the X-direction is preferably 15° to 75°.

When the electrode connection parts 84 are formed in a mesh-like shape, the width $L_5$ of the first and second narrow lines 841a and 841b is preferably 5 μm to 20 μm. The height of the first and second narrow lines 841a and 841b is preferably 0.5 μm to 20 μm. The pitch $P_5$ between adjacent first narrow lines 841a and 841a (between adjacent second narrow lines 841b and 841b) is preferably 10 μm to 100 μm. The angle (acute angle side) formed between each of the first and second narrow lines 841a and 841b and the X-direction is preferably 15° to 75°.

The width $L_4$ of the first and second narrow lines 824a and 824b is preferably 1 to 20 times the width $L_6$ of the second electrode lines 812a and 812b. The width $L_5$ of the first and second narrow lines 841a and 841b is preferably 1 to 20 times the width $L_6$ of the second electrode lines 812a and 812b. The pitch $P_4$ between adjacent first narrow lines 824a and 824a (between adjacent second narrow lines 824b and 824b) is preferably 0.01 to 1 times the pitch $P_6$ between adjacent second electrode lines 812a and 812a (between adjacent second electrode lines 812b and 812b). The pitch $P_5$ between adjacent first narrow lines 841a and 841a (between adjacent second narrow lines 841b and 841b) is preferably 0.01 to 1 times the pitch $P_6$ between adjacent second electrode lines 812a and 812a (between adjacent second electrode lines 812b and 812b).

The second electrode patterns 811 are connected to the second lead wires 82 via the electrode connection parts 84 in the present embodiment, but the present invention is not limited to this, and the second electrode patterns 811 may be connected to the second lead wires 82 without via electrode connection parts 84. The "second lead wires 82" in the present embodiment correspond to an example of the "second lead wire" in the present invention and the "second terminals 85" in the present embodiment correspond to an example of the "second terminal" in the present invention.

Referring again to FIG. 9, the second shield layer 83 is a conductive layer composed of the same material as the material which constitutes the second electrodes 81, and is a shield layer that electromagnetically shields the first lead wires 62 of the first conductor layer 60. The second shield layer 83 is formed substantially on the same plane as the second electrodes 81 and the second lead wires 82. The second shield layer 83 is provided so as to be electrically insulated from the second electrodes 81 and the second lead wires 82. The second shield layer 83, like the above-described second lead wires 82, is formed within a region that excludes the region overlapping the display part 91 of the image display device 90 in the plan view.

The second shield layer 83 is connected to the terminal 86 for the shield layer and can be connected to an external circuit (not illustrated) via the terminal 86 for the shield layer. The external circuit connected to the terminal 86 for the shield layer is grounded, and the second shield layer 83 is thereby grounded via the external circuit.

The second shield layer 83 of the present embodiment is configured such that a plurality of second shield lines 831a and 831b having conductivity intersects with one another, and has a mesh-like shape as a whole in which squares are repeated.

Specifically, like the first shield lines 631a, each second shield line 831a extends linearly along the third direction, and the plurality of the second shield lines 831a is arranged at a regular pitch in the fourth direction. On the other hand, each second shield line 831b extends linearly along the fourth direction, and the plurality of the second shield lines 831b is arranged at a regular pitch in the third direction. The second shield lines 831a and 831b are orthogonal to one another, and the second shield layer 83 is thereby formed in which unit meshes of square shapes are repeated.

The structure of the second shield layer 83 formed into a mesh-like shape is not particularly limited to the above. For example, the pitch of the second shield lines 831a is substantially the same as the pitch of the second shield lines 831b in the present embodiment, but the present invention is not limited to this, and the pitch of the second shield lines 831a may be different from the pitch of the second shield lines 831b. The second shield lines 831a extend in a direction that is substantially parallel to the first shield lines 631a and the second shield lines 831b extend in a direction that is substantially parallel to the first shield lines 631b in the present embodiment, but the present invention is not limited to this, and they may extend in different directions with respect to the first shied lines 631a and 631b.

In the present embodiment, by providing a large pitch of the second shield lines 831a and 831b or by providing a narrow width of the second shield lines 831a and 831b, it is possible to suppress deterioration of the flexibility of the wiring board 20 (wiring body 40) comprising the second shield lines 831a and 831b. In an alternative embodiment, by providing a small pitch of the second shield lines 831a and 831b or by providing a wide width of the second shield lines 831a and 831b, it is possible to improve the shield property of the second shield layer 83 for the first lead wires 62.

Also in the second shield layer 83, a geometrical pattern obtained by repeating any of various figure units can be used as the shape of unit meshes of the second shield layer 83 as in the first shield layers 63. In the present embodiment, the second shield lines 831a and 831b are in a straight line-like form, but the present invention is not limited to this, and they may be in a specific form, such as a curved form, horseshoe-like form and zigzag form.

The width of such second shield lines 831a and 831b is preferably 5 $\mu$m to 20 $\mu$m. The height of the second shield lines 831a and 831b is preferably 0.5 $\mu$m to 20 $\mu$m. The pitch between adjacent second shield lines 831a and 831a (between adjacent second shield lines 831b and 831b) is preferably 10 $\mu$m to 1000 $\mu$m. The angle (acute angle side) formed between each of the second shield lines 831a and 831b and the X-direction is preferably 30° to 55°.

The width of the second shield lines 831a and 831b is preferably 1 to 20 times the width $L_6$ of the second electrode lines 812a and 812b. The pitch between adjacent second shield lines 831a and 831a (between adjacent second shield lines 831b and 831b) is preferably 2 to 1000 times the pitch $P_6$ between adjacent second electrode lines 812a and 812a (between adjacent second electrode lines 812b and 812b).

In the following description, the second shield lines 831a and 831b will be referred to as second shield lines 831 as necessary, and the second electrode lines 812, the second lead wires 82 and the second shield lines 831 will be referred to as conductor lines 812, 82, and 831. The "second shield layer 83" in the present embodiment corresponds to an example of the "second shield layer" in the present invention.

Referring again to FIG. 3 and FIG. 4, each of side surfaces 815, 823, and 834 of the conductor lines 812, 82, and 831 which constitute the second conductor layer 80 merges into a side part of the protrusions 71 of the second resin layer 70, which are in contact with the conductor lines 812, 82, and 831, to form one flat surface. The conductor lines 812, 82, and 831 have tapered shapes that narrow toward the +Z-direction in the figures, so that the cross-sectional shapes (cross-sectional shapes in the transverse directions) of the conductor lines 812, 82, and 831 are approximately trapezoidal shapes. The cross-sectional shapes of the conductor lines 812, 82, and 831 are not particularly limited to the above. For example, the cross-sectional shapes of the conductor lines 812, 82, and 831 may be other shapes, such as square shapes, rectangular shapes, and triangular shapes.

The conductor lines 812, 82, and 831 are in contact with the second resin layer 70 at the lower surfaces 813, 821, and 832.

Outer shapes of the conductor lines 812, 82, and 831 will be described below in detail with reference to FIG. 10 by exemplifying a second electrode line 812. As will be understood, the second lead wires 82 and the second shield lines 831 have the same basic structures as that of the second electrode line 812. FIG. 10 therefore illustrates only the second electrode line 812, and the corresponding reference numerals for the second lead wires 82 and the second shield lines 831 are parenthesized. Thus, the description for the second electrode line 812 will be borrowed herein to omit repetitive description.

The upper surface 814 of the second electrode line 812 is located at the opposite side to the lower surface 813 in the second electrode line 812. The upper surface 814 is substantially parallel to the main surface of the substrate 30A (upper surface of the main part 52 of the first resin layer 50 or upper surface of the main part 72 of the second resin layer 70).

The upper surface 814 includes a flat part 8141 in the cross-section of the second electrode line 812 in its width direction. The flat part 8141 is a straight line-like portion (i.e. portion with a considerably large radius of curvature) that exists on the upper surface 814 in the cross-section of the second electrode line 812 in its width direction, and the flatness of the flat part 8141 is 0.5 $\mu$m or less. The flatness of the flat part 8141 can be measured in the same manner as in the above-described method of measuring the flatness of the flat part 6141.

The flat part 8141 of the present embodiment is formed at approximately the entire area of the upper surface 814. The location at which the flat part 8141 is formed is not particularly limited to the above, and the flat part 8141 may be formed at a part of the upper surface 814. In this case, for example, the flat part may be formed at a region that does not include both ends of the upper surface. When the flat part is formed at a part of the upper surface, the width of the flat part may be at least 1/2 or more of the width of the upper surface.

Each side surface 815 is located between the upper surface 814 and the lower surface 813. The side part 815 connects to the upper surface 814 at a first portion 8151 and connects to the lower surface 813 at a second portion 8152. The second electrode line 812 of the present embodiment has a tapered shape that narrows toward the side departing from the first conductor layer 60 and, therefore, the second portion 8152 is located outside the first portion 8151. In the cross-section of the second electrode line 812 in its width direction, the side surface 815 represents a surface that extends on a virtual straight line (not illustrated) passing through the first and second portions 8151 and 8152.

The shape of the side surface 815 is not particularly limited to the above. For example, the side surface 815 may be in an arc shape that protrudes outward in the cross-section of the second electrode line 812 in its width direction. In this case, the side surface 815 exists outside the virtual straight line passing through the first and second portions 8151 and 8152. In other words, the shape of the side surface 815 may preferably be a shape in which a part of the side surface 815 does not exist inside the virtual straight line passing through the first and second portions 8151 and 8152, in the cross-section of the second electrode line 812 in its width direction. For example, when the outer shape (width) of the second electrode line 812 gradually becomes larger as approaching the second resin layer 70 in the cross-section of the second electrode line 812 in its width direction, if the side surface 815 is in an arc shape that protrudes inward (i.e., if the second electrode line 812 is in a divergent shape with its spread bottom), the light incident to the wiring body may readily undergo diffuse reflection.

The side surface 815 of the present embodiment includes a flat part 8153 in the cross-section of the second electrode line 812 in its width direction. The flat part 8153 is a straight line-like portion (i.e. portion with a considerably large radius of curvature) in the cross-section of the second electrode line 812 in its width direction, and the flatness of the flat part 8153 is 0.5 μm or less. The flatness of the flat part 8153 can be measured in the same manner as in the above-described method of measuring the flatness of the flat part 6153. In the present embodiment, the flat part 8153 is formed at approximately the entire area of the side surface 815. The shape of the flat part 8153 is not particularly limited to the above, and the flat part 8153 may be formed at a part of the side surface 815.

From the viewpoint of suppressing the diffuse reflection of light at the side surface 815, an angle $\theta_2$ between the side surface 815 and the upper surface 814 is preferably 90° to 170° ($90° \leq \theta_2 \leq 170°$) and more preferably 90° to 120° ($90° \leq \theta_2 \leq 120°$). In the present embodiment, in one second electrode line 812, the angle between one side surface 815 and the upper surface 814 is substantially the same as the angle between the other side surface 815 and the upper surface 814. In one second electrode line 812, the angle between one side surface 815 and the upper surface 814 may be different from the angle between the other side surface 815 and the upper surface 814.

The surface roughness of the lower surface 813 of the second electrode line 812 in the present embodiment is preferably rougher than the surface roughness of the upper surface 814 of the second electrode line 812. Since the upper surface 814 includes the flat surface 8141 in the present embodiment, the above relative relationship of the surface roughness in the second electrode line 812 (relationship that the surface roughness of the lower surface 813 is relatively rougher than the surface roughness of the upper surface 814) is established. This can increase the contact area between the second conductor layer 80 (specifically the second electrode line 812) and the second resin layer 70 and tightly fix the second conductor layer 80 to the second resin layer 70.

Specifically, the surface roughness Ra of the lower surface 813 of the second electrode line 812 is preferably about 0.1 μm to 3 μm while the surface roughness Ra of the upper surface 814 is preferably about 0.001 μm to 1.0 μm. The surface roughness Ra of the lower surface 813 of the second electrode line 812 is more preferably 0.1 μm to 0.5 μm and the surface roughness Ra of the upper surface 814 is furthermore preferably 0.001 μm to 0.3 μm. The ratio of the surface roughness of the upper surface 814 and the surface roughness of the lower surface 813 (ratio of the surface roughness of the upper surface 814 to the surface roughness of the lower surface 813) is preferably 0.01 or more and less than 1 and more preferably 0.1 or more and less than 1. The surface roughness of the upper surface 814 is preferably 1/5 or less of the width (maximum width) of the second electrode line 812. Such surface roughness can be measured in accordance with a JIS method (JIS B0601 (revised on March 21, 2013)). Measurement of the surface roughness of the upper surface 814 and the lower surface 813 may be performed along the width direction of the second electrode line 812 and may also be performed along the extending direction of the second electrode line 812.

In the present embodiment, the side surface 815 includes the flat part 8153. The surface roughness of the lower surface 813 is therefore relatively rougher than that of the side surface 815. Specifically, the surface roughness Ra of the lower surface 813 of the second electrode line 812 is preferably 0.1 μm to 3 μm while the

surface roughness Ra of the side surface 815 is preferably 0.001 μm to 1.0 μm. In an embodiment, the surface roughness Ra of the side surface 815 of the second electrode line 812 is more preferably 0.001 μm to 0.3 μm. Measurement of the surface roughness of the side surface 815 may be performed along the width direction of the second electrode line 812 and may also be performed along the extending direction of the second electrode line 812.

In the present embodiment, the surface roughness of the lower surface 813 is relatively rougher than the surface roughness of the upper surface 814 and side surfaces 815 and, therefore, the diffuse reflectance of the wiring body 40 at other surfaces than the lower surface 813 (i.e. at the upper surface 814 and side surfaces 815) is relatively smaller than the diffuse reflectance of the wiring body 40 at the lower surface 813. The ratio of the diffuse reflectance of the wiring body 40 at other surfaces than the lower surface 813 and the diffuse reflectance of the wiring body 40 at the lower surface 813 (ratio of the diffuse reflectance of the wiring body 40 at other surfaces than the lower surface 813 to the diffuse reflectance of the wiring body 40 at the lower surface 813) is preferably 0.1 or more and less than 1 and more preferably 0.3 or more and less than 1 from the viewpoint of improving the visibility of the wiring body 40.

A similar shape to that of the first electrode line 612B illustrated in FIG. 8 can be exemplified as an example of the shape of a second electrode line that has the above-described relative relationship of the surface roughness between the lower surface and other surfaces than the lower surface. This will be described in more detail. In the lower surface of the second electrode line, a part of the conductive powder particles protrudes from the binder resin in the cross-section of the second electrode line in its width direction. On the other hand, in the upper surface and side surfaces of the second electrode line, the binder resin gets into spaces between the conductive powder particles in the cross-section of the second electrode line in its width direction, and the binder resin covers the conductive powder particles. In this case, the lower surface has an uneven shape, and the upper surface includes a flat part. The surface roughness of the lower surface of the second electrode line is therefore relatively rougher than the surface roughness of the upper surface of the second electrode line. In this example, the side surfaces of the second electrode line also include flat parts. The surface roughness of the lower surface of the second electrode line is therefore relatively rougher than the surface roughness of the side surfaces of the second electrode line. Forms of the lower surface 813, upper surface 814, and side surfaces 815 of each second electrode line 812 are not particularly limited to the above-described forms.

The second electrode lines 812, the second lead wires 82, and the second shield lines 831 may have different widths. The second electrode lines 812, the second lead wires 82, and the second shield lines 831 may have different heights. The surface roughness of lower surfaces 813 of the second electrode lines 812, the surface roughness of lower surfaces 821 of the second lead wires 82, and the surface roughness of lower surfaces 832 of the second shield lines 831 may be the same or different. The surface roughness of upper surfaces 814 of the second electrode lines 812, the surface roughness of upper surfaces 822 of the second lead wires 82, and the surface roughness of upper surfaces 833 of the second shield lines 831 may be the same or different. In FIG. 3 and FIG. 4, the second electrode lines 812, the second lead wires 82, and the second shield lines 831 have similar shapes, but the present invention is not particularly limited to this. When the second lead wires 82 have a mesh-like shape, the basic structure of the first and second narrow lines 824a and 824b which constitute the second lead wires 82 is the same as the basic structure of the conductor lines 812, 82, and 831. Similarly, when the electrode connection parts 84 have a mesh-like shape, the basic structure of the first and second narrow lines 841a and 841b which constitute the electrode connection parts 84 is the same as the basic structure of the conductor lines 812, 82, and 831.

In the wiring body 40 of the present embodiment, it is preferred that the following Expression (3) be established:

$$0.5 \leq A_2 \ldots (3).$$

In the above Expression (3), $A_2$ is a maximum value of $C_2/B_2$, $B_2$ is a width of the second conductor layer 80 in the cross-sectional view in the transverse direction, and $C_2$ is a height of the second conductor layer 80 in the cross-sectional view in the transverse direction.

As used herein, the "width $B_2$ of the second conductor layer 80 in the cross-sectional view in the transverse direction" refers to each of widths of the conductor lines 812, 82, and 831 in their extending directions and, in the present embodiment, corresponds to each of widths of the lower surfaces 813, 821, and 832. The "height $C_2$ of the second conductor layer 80 in the cross-sectional view in the transverse direction" refers to each of heights (thicknesses) of the conductor lines 812, 82, and 831 having the width $B_2$ and, in the present embodiment, corresponds to each of distances between the lower surfaces 813, 821, and 832 and the upper surfaces 814, 822, and 833. The parameter $A_2$ in the present embodiment therefore refers to the maximum value of a ratio of the height $C_2$ to the width $B_2$ of each of the conductor lines 812, 82, and 831.

In the present embodiment, the above Expression (3) is preferably established in at least one of the second electrode lines 812, the second lead wires 82, and the second shield lines 831 and more preferably established in all of the second electrode lines 812, the second lead wires 82, and the second shield lines 831.

The image display device 90 of the present embodiment is, for example, a liquid crystal display (LCD) and, as illustrated in FIG. 2, comprises the display part 91 and a base part 92 that supports the display part 91. The image display device 90 is attached directly to a main surface 32A side (i.e. lower side of the first conductor layer 60) of the first substrate 30A via a transparent pressure-sensitive adhesive layer 93. The transparent pressure-sensitive adhesive layer 93 is applied to the entire main surface 32A of the first substrate 30A with no space between the first substrate 30A and the image display device 90 thereby to ensure good appearance of the display part 91. The transparent pressure-sensitive adhesive layer 93 is formed of a material having insulation properties and specific examples include an acrylic-based pressure-sensitive adhesive.

The display part 91 displays, for example, various icons for operation, textual information in response to the operation command input by an operator, and other information. The display part 91 of the present embodiment is a liquid crystal panel formed of a plate-like member that includes a liquid crystal composition. On the other hand, the base part 92 is provided with an electrical circuit or the like for supplying electrical signals to the display part 91. Thus, in the image display device 90 of the present embodiment, the electrical circuit applies a voltage to the display part 91 to form an electrical field, thereby varying the liquid crystal orientation of the display part 91 (liquid crystal composition), and the light emitted from a light source such as a backlight (not illustrated) is partially blocked and partially transmitted in response to the liquid crystal orientation of the liquid crystal composition to perform certain display on the display part 91. The image display device 90 is not particularly limited to the above and may also be, for example, a plasma display, organic electroluminescence display, field emission display, electronic paper, or the like.

The cover panel 110, which is disposed above the second conductor layer 80, is provided from the viewpoint of preventing the first and second conductor layers 60 and 80, etc., from damage and degradation such as discoloration. As illustrated in FIG. 11, the cover panel 110 comprises a transparent part 111 through which visible light can transmit and a masked part 112 through which visible light cannot transmit. Examples of a material that constitutes the cover panel 110 include glass, polymethyl methacrylate (PMMA), and polycarbonate (PC), but a material having a total light transmittance of 90% or higher is preferred.

The masked part 112 is formed, for example, by applying a black ink to the back surface of the cover panel 110. The black ink is not applied to a rectangular region located at approximately the middle of the back surface of the cover panel 110, and the transparent part 111 through which visible light transmits is thereby formed. That is, the masked part 112 is formed to have a frame-like shape that surrounds the transparent part 111 in the plan view.

The transparent part 111 is formed to correspond to the display part 91 of the image display device 90 and disposed to overlap the display part 91. The masked part 112 is formed within a region that excludes the region overlapping the display part 91. The above-described first and second lead wires 62 and 82 and first and second shield layers 63 and 83 are thus not visible through the masked part 112.

As illustrated in FIG. 2 to FIG. 4, the wiring board 20 (wiring body 40) described hereinbefore is formed with the first resin layer 50, the first conductor layer 60, the second resin layer 70, and the second conductor layer 80 which are located in this order from below toward above. As a result, in the present embodiment, the image display device 90 is disposed at the side closer to the first electrodes 61 as drive-side electrodes than the second electrodes 81 as detection-side electrodes.

In the present embodiment, the first shield layers 63 are disposed so as to overlap the second lead wires 82 in the plan view (see FIG. 3 and FIG. 9). That is, the first shield layers 63 shield between the image display device 90 and the second lead wires 82. According to this structure, the electrical noise emitted from the image display device 90 is suppressed from transmitting to the second lead wires 82 and the occurrence of erroneous operation of the touch sensor 1 is thus suppressed.

In the present embodiment, as illustrated in FIG. 12(a), the first shield layers 63 are each composed of the first shield lines 631a and 631b which extend in the directions inclined with respect to the X-direction and the Y-direction. This structure prevents the extending directions of the first shield lines 631 and the extending direction of the second lead wires 82 from being substantially the same (from being parallel) in the plan view. This results in a uniform shield effect because, in the plan view, overlapping portions of the second lead wires 82 with the first shield layers 63 are suppressed from being ununiformly distributed. The first shield layers 63 of the present embodiment are formed also to shield the electrode connection parts 84 from the image display device 90.

On the other hand, the second shield layer 83 is disposed so as to overlap the first lead wires 62 in the plan view (see FIG. 4 and FIG. 9). That is, the second shield layer 83 shields the first lead wires 62 from external. According to this structure, the electrical noise from external is suppressed from transmitting to the first lead wires 62, and the occurrence of erroneous operation of the touch sensor 1 is thus suppressed.

As illustrated in FIG. 12(b), the second shield layer 83 is composed of the second shield lines 831a and 831b which extend in the directions inclined with respect to the X-direction and the Y-direction. This structure prevents the extending directions of the second shield lines 831 and the extending direction of the first lead wires 62 from being substantially the same (from being parallel) in the plan view. This results in a uniform shield effect because, in the plan view, overlapping portions of the first lead wires 62 with the second shield layer 83 are suppressed from being ununiformly distributed. The second shield layer 83 of the present embodiment is formed also to shield the electrode connection parts 64 from external.

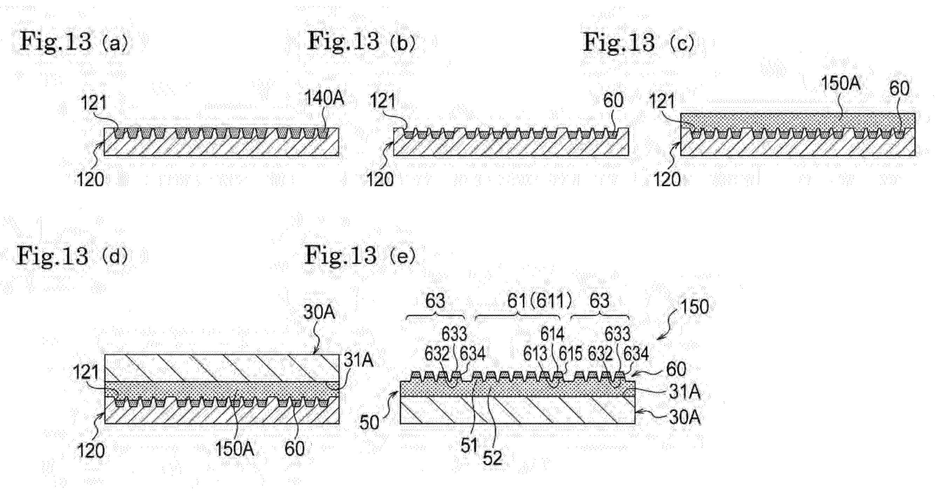

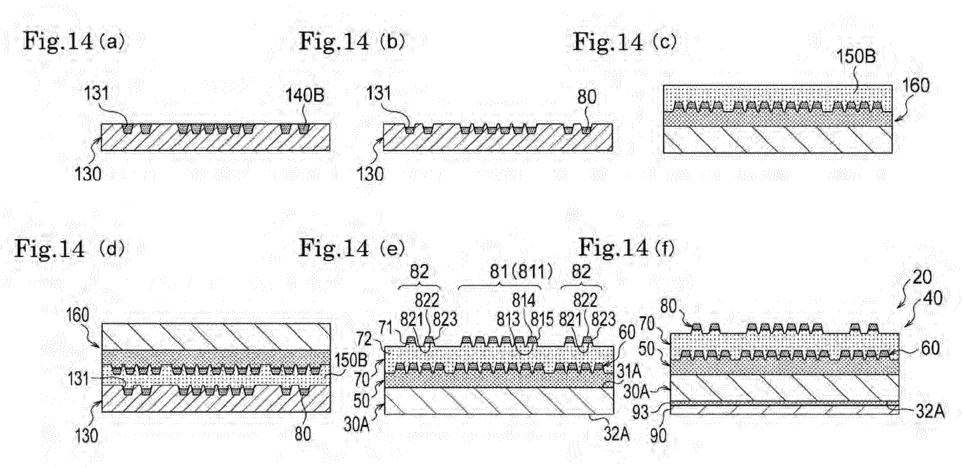

A production method for the wiring board 20 in the present embodiment will then be described. FIG. 13(a) to FIG. 13(e) are cross-sectional views for describing a production method (part 1) for a wiring board in an embodiment of the present invention and FIG. 14(a) to FIG. 14(f) are cross-sectional views for describing the production method (part 2) for a wiring board in an embodiment of the present invention.

First, a first recessed plate 120 is prepared as illustrated in FIG. 13(a). The first recessed plate 120 is formed with recesses 121 that correspond to shapes of the first electrodes 61, first lead wires 62, and first shield layers 63 in the first conductor layer 60. Examples of a material that constitutes the first recessed plate 120 include nickel, silicon, glasses such as silicon dioxide, organic silicas, glassy carbon, thermoplastic resin, and thermoset resin.

The width and depth of the recesses 121 are different in each element that constitutes the first conductor layer 60. In the present embodiment, the width of recesses 121 formed in a shape corresponding to that of the first electrodes 61 is preferably 1 μm to 5 μm. The depth of recesses 121 formed in the shape corresponding to that of the first electrodes 61 is preferably 0.5 μm to 10 μm.

The width of recesses 121 formed in a shape corresponding to that of the first lead wires 62 is preferably 10 μm to 100 μm. The depth of recesses 121 formed in the shape corresponding to that of the first lead wires 62 is preferably 0.5 μm to 20 μm.

The width of recesses 121 formed in a shape corresponding to that of the first shield layers 63 is preferably 5 μm to 20 μm. The depth of recesses 121 formed in the shape corresponding to that of the first shield layers 63 is preferably 0.5 μm to 20 μm.

In the present embodiment, cross-sectional shapes of the recesses 121 are each formed in a tapered shape that narrows toward the bottom part. To improve releasability, it is preferred for the surfaces of the recesses 121 to be preliminarily formed with release layers composed of an appropriate material, such as a black lead-based material, silicone-based material, fluorine-based material, ceramic-based material, and aluminum-based material.

Then, the above-described first recessed plate 120 is filled with a conductive material 140A. The conductive paste as described above may be used as such a conductive material 140A.

Examples of a method of filling the recesses 121 of the recessed plate 120 with the conductive material 140A include a dispensing method, ink-jet method, and screen printing method. Another possible method may include coating with a conductive material, such as by a slit-coating method, bar-coating method, blade-coating method, dip-coating method, spray-coating method and spin-coating method, and then wiping, scratching, suctioning, peeling, washing, or blowing away the conductive material applied to other parts than the recesses. An appropriate method can be selected in accordance with the composition or the like of the conductive material and the shape or the like of the recessed plate.

Then, as illustrated in FIG. 13(b), the conductive material 140A which fills the recesses 121 of the first recessed plate 120 is heated to form conductor patterns that constitute the first conductor layer 60. That is, in the present embodiment, the first electrodes 61, first lead wires 62 and first shield layers 63 which constitute the first conductor layer 60 can be formed integrally with one another in the same process. In this case, the first electrodes 61, the first lead wires 62, and the first shield layers 63 are formed on the same plane. As used herein, the term "integrally with" refers to a situation in which a member and another member are not separated from each other and they are formed as a one-body structure using the same material (such as using conductive particles of the same particle diameter and the same binder resin).

A heating condition for the conductive material 140A can be appropriately set in accordance with the composition or the like of the conductive material. Due to this heat treatment, the conductive material 140A undergoes volume contraction. During this treatment, upper surfaces of the conductive material 140A are formed into uneven surfaces (surfaces corresponding to the lower surfaces 613, 621, and 632), and other surfaces than the upper surfaces of the conductive material 140A are formed into shapes that follow the recesses 121. The treatment method for the conductive material 140A is not limited to heating. For example, the conductive material 140A may be irradiated with energy rays, such as infrared rays, ultraviolet rays and laser light, or may be simply dried. Two or more treatment methods as the above may be employed in combination.

Then, as illustrated in FIG. 13(c), a resin material 150A for forming the first resin layer 50 is applied onto the first recessed plate 120. The same material as the above-described material which constitutes the first resin layer 50 can be used as such a resin material 150A. Examples of a method of applying the resin material 150A onto the first recessed plate 120 include a screen printing method, spray-coating method, bar-coating method, dip method, and ink-jet method. The resin material 150A gets into spaces formed in the recesses 121 due to volume contraction of the conductive material 140A and comes into contact with the upper surfaces, which are uneven surfaces, of the conductive material 140A. This allows the conductive material 140A and the resin material 150A to be tightly fixed to each other.

Then, as illustrated in FIG. 13(d), the first substrate 30A is pressed against the resin material 150A from above. Then, the resin material 150A is cured. Examples of a method of curing the resin material 150A include irradiation with energy rays, such as ultraviolet rays, infrared rays and laser light, heating, heating and cooling, and drying. Thus, the first resin layer 50 is formed, and the first substrate 30A and the first conductor layer 60 adhere to and are fixed to each other via the first resin layer 50.

Then, as illustrated in FIG. 13(e), the first substrate 30A, the first resin layer 50, and the first conductor layer 60 are released from the first recessed plate 120. This transfers the first conductor layer 60 from the first recessed plate 120 to the first resin layer 50, and an intermediate body 160 is obtained.

Next, a second recessed plate 130 is prepared as illustrated in FIG. 14(a). The second recessed plate 130 is formed with recesses 131 that correspond to shapes of the second electrodes 81, second lead wires 82, and second shield layer 83 in the second conductor layer 80. The same material as the above-described material which constitutes the first recessed plate 120 can be exemplified as a material that constitutes the second recessed plate 130.

The width and depth of the recesses 131 are different in each element that constitutes the second conductor layer 80, but preferably have comparable values with the width and depth of the recesses 121 in each element that constitutes the first conductor layer 60. In the present embodiment, cross-sectional shapes of the recesses 131 are each formed in a tapered shape that narrows toward the bottom part. It is preferred for the surfaces of the recesses 131 also to be formed with release layers as in the case of the recesses 121.

Then, the second recessed plate 130 is filled with a conductive material 140B. The same material as that of the above-described conductive material 140A can be exemplified as the conductive material 140B. The same method as the above-described method of filling the first recessed plate 120 with the conductive material 140A can be exemplified as a method of filling the second recessed plate 130 with the conductive material 140B.

Then, as illustrated in FIG. 14(b), the conductive material 140B which fills the recesses 131 of the second recessed plate 130 is heated to form conductor patterns that constitute the second conductor layer 80. That is, in the present embodiment, the second electrodes 81, second lead wires 82 and second shield layer 83 which constitute the second conductor layer 80 can be formed integrally with one another in the same process. In this case, the second electrodes 81, the second lead wires 82, and the second shield layer 83 are formed on the same plane.

A heating condition for the conductive material 140B can be appropriately set in accordance with the composition or the like of the conductive material 140B. Due to this heat treatment, the conductive material 140B which fills the recesses 131 undergoes volume contraction. During this treatment, upper surfaces of the conductive material 140B are formed into uneven surfaces (surfaces corresponding to the lower surfaces 813, 821, and 832), and other surfaces than the upper surfaces of the conductive material 140B are formed into shapes that follow the recesses 131. The treatment method for the conductive material 140B is not limited to heating, and the above-described possible treatment methods for the conductive material 140A may also be used.

Then, as illustrated in FIG. 14(c), a resin material 150B that forms the second resin layer 70 is applied onto the intermediate body 160. The same material as the above-described material which constitutes the second resin layer 70 can be used as such a resin material 150B. The same method as the method of applying the resin material 150A onto the first recessed plate 120 can be exemplified as a method of applying the resin material 150B onto the intermediate body 160.

Then, as illustrated in FIG. 14(d), the intermediate body 160 and the resin material 150B are disposed on the second recessed plate 130 and the intermediate body 160 is pressed against the second recessed plate 130 so that the resin material 150B gets into the recesses 131 of the second recessed plate 130, and the resin material is cured. The same method as the above-described method of curing the resin material 150A can be exemplified as a method of curing the resin material 150B.

The pressing pressure when pressing the intermediate body 160 against the second recessed plate 130 is preferably 0.001 MPa to 100 MPa and more preferably 0.01 MPa to 10 MPa. The pressing can be performed, such as using pressure rollers. Thus, the second resin layer 70 is formed, and the intermediate body 160 and the second conductor layer 80 adhere to and are fixed to each other via the second resin layer 70. During this operation, the intermediate body 160 is pressed against the second recessed plate 130 so that the first electrodes 61 overlap the second electrodes in the plan view. In addition, the intermediate body 160 is pressed against the second recessed plate 130 so that the first shield layers 63 overlap the second lead wires 82 and the second shield layer 83 overlaps the first lead wires 62 in the plan view.

Then, as illustrated in FIG. 14(e), the intermediate body 160, the second resin layer 70, and the second conductor layer 80 are released from the second recessed plate 130. Then, as illustrated in FIG. 14(f), a transparent pressure-sensitive adhesive is applied to the entire main surface 32A of the first substrate 30A. The same method as the above-described method of applying the resin material 150A to the first recessed plate 120 can be exemplified as a method of applying the transparent pressure-sensitive adhesive. Then, the image display device 90 is attached to the main surface 32A of the first substrate 30A via the transparent pressure-sensitive adhesive. When the transparent pressure-sensitive adhesive is cured to form the transparent pressure-sensitive adhesive layer 93, the wiring board 20 of the present embodiment can be obtained.

The wiring body 40 and wiring board 20 of the present embodiment have the following effects.

In a conventional touch sensor in which two electrode boards are laid on each other via an insulation material, when a shield layer is provided to shield a lead wire that is connected to an electrode formed on each of the two electrode board, each of the shield layers is formed to correspond the lead wire. That is, a lead wire and a shield layer are formed on different planes, an insulation layer is interposed between the lead wire and the shield layer thereby to allow the shield layer to shield the lead wire from external, and the electrical noise from external is suppressed from transmitting to the lead wire. However, there is a problem in that the height (thickness) of the wiring body increases because the insulation layer interposed between the lead wire and the shield layer has to be formed for respective lead wires connected to two electrodes. In addition, if the insulation layer is formed for respective lead wires connected to two electrodes, the number of production steps for the wiring body increases to raise the production cost of the wiring body, which may also be problematic.

In contrast, according to the present embodiment, in the two conductor layers 60 and 80 which face each other via the second resin layer 70, the first shield layers 63 of the first conductor layer 60 as one conductor layer shield the second lead wires 82 of the second conductor layer 80 as the other conductor layer. This allows the second resin layer 70 to ensure the insulation between the first shield layers 63 and the second lead wires 82. As a result, it is not necessary to separately ensure the insulation between the first shield layers 63 and the second lead wires 82, and the height (thickness) of the wiring body 40 and the wiring board 20 can be suppressed from increasing.

Moreover, in the first conductor layer 60, it is not necessary to separately ensure the insulation between the first shield layers 63 and the first lead wires 62. The number of production steps for the wiring body 40 and the wiring board 20 is therefore suppressed from increasing, and the production cost of the wiring body 40 and the wiring board 20 is thus reduced.

In the present embodiment, the image display device 90 is disposed below the first conductor layer 60. The first shield layers 63 shield the second lead wires 82 as described above, and the electrical noise emitted from the image display device 90 is thereby suppressed from transmitting to the second lead wires 82. The occurrence of erroneous operation of the touch sensor 1 can thus be suppressed.

In the present embodiment, the first resin layer 50 is interposed between the image display device 90 and the first conductor layer 60 thereby to reduce the electrical noise emitted from the image display device 90. The electrical noise emitted from the image display device 90 is therefore further suppressed from transmitting to the second lead wires 82, and the occurrence of erroneous operation of the touch sensor 1 can thus be suppressed.

In the present embodiment, the first conductor layer 60 is embedded in the second resin layer 70. The thickness of the first conductor layer 60 can therefore be absorbed by the thickness of the second resin layer 70. On the other hand, the second conductor layer 80 is provided on the second resin layer 70. The second resin layer 70 is therefore interposed between the first and second conductor layers 60 and 80, and it is not necessary to separately ensure the insulation between these conductor layers. This can reduce the thickness of the wiring body 40.

In general, a shield layer is disposed in the vicinity of an object to be shielded by the shield layer, thereby to improve the electromagnetic shielding ability to the object. To this end, in the present embodiment, the first shield layers 63 are embedded in the second resin layer 70 to come close to the second lead wires 82 via the second resin layer 70. This can improve the shielding ability of the first shield layers 63 to the second lead wires 82.

In general, as the thickness of a lead wire itself increases, the conduction path of the lead wire expands to improve the signal transmission performance. To this end, in the present embodiment, the second lead wires 82 are provided on the second resin layer 70, and the height of the second lead wires 82 can therefore be set independent of the thickness of the second resin layer 70. This can improve the signal transmission performance of the second lead wires 82.

In particular, in the present embodiment, the first conductor layer 60 is embedded in the second resin layer 70 and the second conductor layer 80 is provided on the second resin layer 70. It is thereby possible to simultaneously realize the above-described reduction in thickness of the wiring body 40, improvement in the shielding ability of the first shield layers 63, and improvement in the signal transmission performance of the second lead wires 82.

In the present embodiment, the second shield layer 83 of the second conductor layer 80 as one conductor layer shields the first lead wires 62 of the first conductor layer 60 as the other conductor layer. It is thus not necessary to separately ensure the insulation between the first lead wires 62 and the second shield layer 83, and the height (thickness) of the wiring body 40 and the wiring board 20 can be suppressed from increasing.

In the second conductor layer 80, it is not necessary to separately ensure the insulation between the second shield layer 83 and the second lead wires 82. The number of production steps for the wiring body 40 is therefore suppressed from increasing, and the production cost of the wiring body 40 is thus reduced. Moreover, the second shield layer 83 shields the first lead wires 62, and the electrical noise from external is thereby suppressed from transmitting to the first lead wires 62. The occurrence of erroneous operation of the touch sensor 1 can thus be suppressed.

In the present embodiment, the first and second shield layers 63 and 83 are each formed in a mesh-like shape thereby to obtain a uniform shield effect in the wiring body 40 and in the wiring board 20 because, in the plan view, overlapping portions of the first lead wires 62 with the second shield layer 83 or overlapping portions of the second lead wires 82 with the first shield layers 63 are suppressed from being ununiformly distributed.

The conductor lines 612, 62, and 631 of the present embodiment have tapered shapes that narrow toward the second conductor layer 80 side. This can improve the mechanical strength of the conductor lines 612, 62, and 631 against the pressing force when pressing the intermediate body 160 to the second recessed plate 130 as compared with a case in which the conductor lines 612, 62, and 631 are not formed with such tapered shapes and a case in which the conductor lines 612, 62, and 631 are formed with reversed tapered shapes. Thus, the breakage of the conductor lines 612, 62, and 631 is suppressed during the production and the durability of the wiring body 40 is improved. In the present embodiment, the conductor lines 812, 82, and 831 also have similar tapered shapes (tapered shapes that narrow toward the side departing from the first conductor layer 60). This can improve the mechanical strength of the conductor lines 812, 82, and 831 to suppress the breakage, and the durability of the wiring body 40 and the wiring board 20 is therefore further improved.

In the wiring body 40 of the present embodiment, attention is also focused on the relative relationship of the surface roughness (i.e. the roughness parameter obtained by shutting off the waviness components) between the lower surfaces 613, 621, and 632 of the conductor lines 612, 62, and 631 and other surfaces than the lower surfaces 613, 621, and 632 (upper surfaces 614, 622, and 633 and side surfaces 615, 623, and 634) in the cross-sections of the conductor lines 612, 62, and 631 in their width directions, and the surface roughness of the lower surfaces 613, 621, and 632 of the conductor lines 612, 62, and 631 is relatively rougher than the surface roughness of the upper surfaces 614, 622, and 633 of the conductor lines 612, 62, and 631. This increases the contact areas between the conductor lines 612, 62, and 631 and the first resin layer 50, and the conductor lines 612, 62, and 631 are tightly fixed to the first resin layer 50. The durability of the wiring body 40 and the wiring board 20 can therefore be further improved. In addition, the diffuse reflection of incident light from external can be suppressed. In particular, when the width of the conductor lines 612, 62, and 631 is 1 μm to 5 μm, a remarkable effect can be obtained that the relative relationship of the surface roughness between the lower surfaces 613, 621, and 632 and the other surfaces can satisfy the above-described relationship thereby to suppress the diffuse reflection of incident light from external while allowing the first resin layer 50 to tightly adhere to the conductor lines 612, 62, and 631.

Similarly, in the present embodiment, the surface roughness of the lower surfaces 813, 821, and 832 of the conductor lines 812, 82, and 831 is relatively rougher than the surface roughness of the upper surfaces 814, 822, and 833 of the conductor lines 812, 82, and 831. This allows the conductor lines 812, 82, and 831 to be tightly fixed to the second resin layer 70, and the durability of the wiring body 40 and the wiring board 20 can therefore be further improved. In addition, the diffuse reflection of incident light from external can be suppressed. In particular, when the width of the conductor lines 812, 82, and 831 is 1 μm to 5 μm, a remarkable effect can be obtained that the relative relationship of the surface roughness between the lower surfaces 813, 821, and 832 and the other surfaces can satisfy the above-described relationship thereby to suppress the diffuse reflection of incident light from external while allowing the second resin layer 70 to tightly adhere to the conductor lines 812, 82, and 831.

In the present embodiment, the side parts 615, 623, and 634 each extend so as to substantially coincide with the virtual line passing through the first and second portions. In this case, each side part is in a shape in which a part of the side part does not exist inside the virtual straight line passing through the first and second portions in the cross-section of each of the conductor lines 612, 62, and 631 in its width direction, and the diffuse reflection of light incident from outside the wiring body 40 is therefore suppressed. This can further improve the visibility of the wiring body 40.

Similarly, in the present embodiment, the side parts 815, 823, and 834 each extend so as to substantially coincide with the virtual line passing through the first and second portions. In this case, each side part is in a shape in which a part of the side part does not exist inside the virtual straight line passing through the first and second portions in the cross-section of each of the conductor lines 812, 82, and 831 in its width direction, and the diffuse reflection of light incident from outside the wiring body 40 is therefore suppressed. This can further improve the visibility of the wiring body 40.

In the present embodiment, the surface roughness Ra of the lower surfaces 613, 621, and 632 is relatively rougher than the surface roughness Ra of other surfaces than the lower surfaces 613, 621, and 632, and thereby the diffuse reflectance of the wiring body 40 at the other surfaces is relatively smaller than the diffuse reflectance of the wiring body 40 at the lower surfaces 613, 621, and 632. Here, when the diffuse reflectance of the wiring body 40 is small, the conductor lines 612, 62, and 631 can be avoided from being reflected to be white and the contrast degradation can be suppressed in a region in which the conductor lines 612, 62, and 631 are visible. It is thus possible to further improve the visibility of the wiring body 40 of the present embodiment.

Similarly, in the present embodiment, the surface roughness Ra of the lower surfaces 813, 821, and 832 is relatively rougher than the surface roughness Ra of other surfaces than the lower surfaces 813, 821, and 832, and thereby the diffuse reflectance of the wiring body 40 at the other surfaces is relatively smaller than the diffuse reflectance of the wiring body 40 at the lower surfaces 813, 821, and 832. Here, when the diffuse reflectance of the wiring body 40 is small, the conductor lines 812, 82, and 831 can be avoided from being reflected to be white and the contrast degradation can be suppressed in a region in which the conductor lines 812, 82, and 831 are visible. It is thus possible to further improve the visibility of the wiring body 40 of the present embodiment.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, in the above-described embodiments, a metal material or a carbon-based material is used as the conductive powder which constitutes the first and second conductor layers, but the present invention is not limited to this, and a mixture of a metal material and a carbon-based material may also be used. In this case, in an example of the conductor lines 812, 82, and 831, for example, the carbon-based material may be disposed at the side of the upper surfaces 814, 822, and 833 of the conductor lines 812, 82, and 831, and the metal material may be disposed at the side of the lower surfaces 813, 821, and 832. Conversely, the metal material may be disposed at the side of the upper surfaces 814, 822, and 833 of the conductor lines 812, 82, and 831, and the carbon-based material may be disposed at the side of the lower surfaces 813, 821, and 832s.

In the wiring board 20 of the present embodiment, the first substrate 30A is used to support the wiring body 40, but the present invention is not limited to this. For example, the image display device 90 may support the wiring body 40. In other words, the first resin layer 50 may be formed directly on the image display device 90. In this case, the first substrate 30A can be omitted, and it is thus possible to further suppress the increase of the height of the wiring board 20. The "image display device 90" in this example corresponds to an example of the "support body" in the present invention.

In the above example, the image display device 90 supports the wiring body 40, but the cover panel 110 may support the wiring body 40. In other words, a transparent pressure-sensitive adhesive layer may be laid on the second conductor layer 80 and the wiring body 40 may be attached to the cover panel 110 via the transparent pressure-sensitive adhesive layer. This allows the wiring body 40 to be supported by the cover panel 110. The "transparent pressure-sensitive adhesive layer" in this example corresponds to an example of the "second insulation layer" and "third insulation layer" in the present invention, and the "cover panel 110" in this example corresponds to an example of the "support body" in the present invention.

The wiring board 20 illustrated in FIG. 3 may be turned upside down and may be laid on the image display device 90. That is, although not particularly illustrated, the second conductor layer 80 may be attached to the image display device 90 via a transparent pressure-sensitive adhesive layer, the wiring board 20 may be configured such that the second resin layer 70, the first conductor layer 60, and the first resin layer 50 are laid on one another from below toward above, and the first substrate 30A may be laid on the upper surface (i.e. the surface opposite to the first conductor layer 60 side) of the first resin layer 50. In this case, the product may be in a form in which the first substrate 30A is used as a release sheet. When the product is mounted on an object, the first substrate 30A is released and the remaining components are then mounted by adhesion on the object for mounting. The "transparent pressure-sensitive adhesive layer" and "first resin layer 50" in this example correspond to an example of the "second insulation layer" and "third insulation layer" in the present invention, and the "first substrate 30A" and "image display device 90" in this example correspond to an example of the "support body" in the present invention.

In the present embodiment, the first electrodes 61 nearer to the image display device 90 are used as the drive-side electrodes, and the second electrodes 81 farther from the image display device 90 are used as the detection-side electrodes, but the present invention is not limited to this. For example, electrodes at nearer side to the image display device 90 may be used as the detection-side electrodes, and electrodes at farther side from the image display device 90 may be used as the drive-side electrodes.

In the above-described embodiments, the wiring body has been described as being used in a touch sensor, but the use of the wiring body is not particularly limited to this. For example, the wiring body may be used as a heater by flowing current through the wiring body to generate heat, such as by resistance heating. In this case, it is preferred to use a carbon-based material having a relatively high electric resistance value as the conductive material which constitutes the conductor layer. The wiring body may be used as an electromagnetic shield by grounding a part of the conductor part of the wiring body. The wiring body may be used as an antenna.

[Description of Reference Numerals]

| | |
|---|---|
| 1 | Touch sensor |
| 10 | Housing |
| 20, 20B, 20C | Wiring board |
| 30A, 30B | First, second substrate |
| 31A, 31B | Main surface |
| 32A | Main surface |
| 40, 40B, 40C | Wiring body |
| 50 | First resin layer |
| 51 | Protrusion |
| 52 | Main part |

| | |
|---|---|
| 60 | First conductor layer |
| 61 | First electrode (Drive-side electrode) |
| 611 | First electrode pattern |
| 612a, 612b | First electrode line (Conductor line) |
| 613 | Lower surface |
| 614 | Upper surface |
| 6141 | Flat part |
| 615 | Side surface |
| 6151 | First portion |
| 6152 | Second portion |
| 6153 | Flat part |
| 62 | First lead wire (Conductor line) |
| 621 | Lower surface |
| 622 | Upper surface |
| 6221 | Flat part |
| 623 | Side surface |
| 6231 | First portion |
| 6232 | Second portion |
| 6233 | Flat part |
| 63 | First shield layer |
| 631a, 631b | First shield line (Conductor line) |
| 632 | Lower surface |
| 633 | Upper surface |
| 6331 | Flat part |
| 634 | Side surface |
| 6341 | First portion |
| 6342 | Second portion |
| 6343 | Flat part |
| 64 | Electrode connection part |
| 65 | Terminal |
| 66 | Conduction wire |
| 67 | Terminal for shield layer |
| 70 | Second resin layer |
| 71 | Protrusion |
| 72 | Main part |
| 80 | Second conductor layer |
| 81 | Second electrode (Detection-side electrode) |
| 811 | Second electrode pattern |
| 812a, 812b | Second electrode line (Conductor line) |
| 813 | Lower surface |
| 814 | Upper surface |
| 8141 | Flat part |
| 815 | Side surface |
| 8151 | First portion |
| 8152 | Second portion |
| 8153 | Flat part |
| 82 | Second lead wire (Conductor line) |
| 821 | Lower surface |
| 822 | Upper surface |
| 8221 | Flat part |
| 823 | Side surface |
| 8231 | First portion |
| 8232 | Second portion |
| 8233 | Flat part |
| 83 | Second shield layer |
| 831a, 831b | Second shield line (Conductor line) |
| 832 | Lower surface |
| 833 | Upper surface |
| 8331 | Flat part |
| 834 | Side surface |
| 8341 | First portion |
| 8342 | Second portion |
| 8343 | Flat part |
| 84 | Electrode connection part |
| 85 | Terminal |
| 86 | Terminal for shield layer |
| 100 | Third resin layer |
| 90 | Image display device |
| 91 | Display part |
| 92 | Base part |
| 93, 93B | Transparent pressure-sensitive adhesive layer |
| 110 | Cover panel |
| 111 | Transparent part |
| 112 | Masked part |
| 120 | First recessed plate |
| 121 | Recess |
| 130 | Second recessed plate |
| 131 | Recess |
| 140A, 140B | Conductive material |
| 150A, 150B | Resin material |
| 160 | Intermediate body |

## Claims

1. A wiring body comprising:

    a first conductor layer;
    a second conductor layer; and
    a first insulation layer interposed between the first and second conductor layers, wherein

    the first conductor layer includes at least:

    a first electrode;
    a first lead wire electrically connected to the first electrode; and
    a first shield layer electrically insulated from the first electrode and the first lead wire,

    the second conductor layer includes at least:

    a second electrode disposed to face the first electrode; and
    a second lead wire electrically connected to the second electrode,

    the first electrode, the first lead wire, and the first shield layer are formed on substantially same plane,
    the second electrode and the second lead wire are formed on substantially same plane,
    at least a part of the second lead wire overlaps the first shield layer in a plan view,
    the first conductor layer includes a noncontact surface that is not in contact with the first insulation layer, the first conductor layer is embedded in the first insulation layer except the noncontact surface,
the second conductor layer is provided on the first insulation layer,
the first shield layer includes a conductor line,
the conductor line has a tapered shape that narrows toward a side approaching the second lead wire, and
the second lead wire has a tapered shape that narrows toward a side departing from the conductor line.

**2.** The wiring body according to claim 1, wherein
the second conductor layer further includes a second shield layer electrically insulated from the second electrode and the second lead wire and formed on substantially same plane as the second electrode and the second lead wire, and
at least a part of the first lead wire overlaps the second shield layer in the plan view.

**3.** The wiring body according to claim 1 or 2, wherein at least one of the first and second shield layers is formed in a mesh-like shape.

**4.** The wiring body according to claim 3, wherein a surface roughness of the noncontact surface of the first conductor layer is relatively rougher than a surface roughness of other surfaces than the noncontact surface of the first conductor layer.

**5.** The wiring body according to claim 4, a following Expression (1) is satisfied:

$$0.5 \leq A \ldots (1)$$

where A is a maximum value of C/B, B is a width of the first conductor layer in its cross-sectional view, and C is a height of the first conductor layer in its cross-sectional view.

**6.** The wiring body according to any one of claims 1 to 5, further comprising
a second insulation layer covering at least one of the first and second conductor layers.

**7.** A wiring board comprising:

the wiring body according to any one of claims 1 to 6; and
a support body supporting the wiring body.

**8.** The wiring board according to claim 7, further comprising
a third insulation layer interposed between the wiring body and the support body.

**9.** A touch sensor comprising the wiring board according to claim 7 or 8.

Fig.1

1
110
20
90
10
Z
Y
X

20
40
30A
31A
32A
90
91
92
Y
X
Z
66
60
61
III
IV
64
62
86
65
83
XIIb
85
67
80
84
63
82
XIIa
81
III
IV

Fig.2

Fig.3
20
40
W1
C1,W2
C2
B2
B1
31A
32A
X
Z
Y
82
81(811)
812a(812b)
821
822
823
813
814
815
63
61(611)
631a(631b)
612a(612b)
632
633
634
613
614
615
80
71
72
70
60
51
50
52
30A
93
90

W1
C1, W2
C2
B2
B1
31A
32A
82
83
821
822
823
831a(831b)
832
833
834
63
62
631a(631b)
632
633
634
621
622
623
71
72
80
70
60
51
52
50
30A
93
90
X
Y
Z

Fig.4

Fig.5

611
611
611
61
60
30A(50)
612b
612a
66
63
63
631b
631a
64
67
65
62
Y
Z
X

611 (811)
64 (84)
$P_3$ ($P_6$)
$P_3$ ($P_6$)
$P_2$ ($P_5$)
$P_2$ ($P_5$)
62 (82)
$P_1$ ($P_4$)
$P_1$ ($P_4$)
624b (824b)
624a (824a)
$L_1$ ($L_4$)
$L_3$ ($L_6$)
$L_2$ ($L_5$)
612b (812b)
612a (812a)
641b (841b)
641a (841a)

Fig.6

Fig.7

612
(62,631)
6151
(6231,6341)
614
(622,633)
6141
(6221,6331)
$\theta_1$
615(623,634)
6153(6233,6343)
6152(6232,6342)
50
51
52
31A
30A
$B_1$
$C_1$
615
(623,634)
613
(621,632)

Z
X
Y

612B
615B
6153B
50
51
52
31A
30A
614B
6141B
615B
6153B
M
B
613B
Z
X
Y

Fig.8

Fig.9

80
81
611
611
611
60
61
63
30A(50,70)
811
66
811
811
63
84
811
812a
812b
831a
831b
67
83
86
85
82
Y
Z
X

812
(82,831)
8151
(8231,8341)
815(823,834)
8153(8233,8343)
8152(8232,8342)
70
71
72
8141
(8221,8331)
814
(822,833)
$\theta_2$
815
(823,834)
813
(821,832)
$C_2$
$B_2$

Z
X
Y

Fig.10

Fig.11

110
111
112
Y
Z
X

Fig.12 (a)
63
631a
631b
82
70(72)
50(51)
82
Y
X
Z
Fig.12 (b)
831a
831b
62
70(72)
50(52)
62
83
Y
X
Z

Fig.13 (a)
121
120
140A
Fig.13 (b)
121
120
60
Fig.13 (c)
121
120
150A
60
Fig.13 (d)
30A
31A
121
120
150A
60
Fig.13 (e)
150
63
632
633
634
61 (611)
613
614
615
63
632
633
634
60
31A
30A
50
51
52

131
140B
130
131
80
130
150B
160
160
131
150B
80
130
82
822
821
823
81 (811)
814
813
815
82
822
821
823
71
72
70
50
30A
60
31A
30A
32A
20
40
60
32A
80
70
50
30A
93
90

Fig.14 (a)

Fig.14 (b)

Fig.14 (c)

Fig.14 (d)

Fig.14 (e)

Fig.14 (f)

**INTERNATIONAL SEARCH REPORT**

International application No.
PCT/JP2016/055894

A. CLASSIFICATION OF SUBJECT MATTER
*G06F3/041*(2006.01)i, *G06F3/044*(2006.01)i, *H05K1/02*(2006.01)i

According to International Patent Classification (IPC) or to both national classification and IPC

B. FIELDS SEARCHED

Minimum documentation searched (classification system followed by classification symbols)
G06F3/041, G06F3/044, H05K1/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 7-169635 A (Matsushita Electric Industrial Co., Ltd.), 04 July 1995 (04.07.1995), entire text; all drawings & US 5609704 A entire text; all drawings & US 6310304 B1 & US 6378424 B1 | 1-9 |
| Y | JP 2012-203565 A (Dainippon Printing Co., Ltd.), 22 October 2012 (22.10.2012), paragraphs [0006], [0030] to [0050]; fig. 1 to 2B (Family: none) | 1-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 May 2016 (02.05.16) | 17 May 2016 (17.05.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No. PCT/JP2016/055894

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2014-71863 A (Fujikura Ltd.), 21 April 2014 (21.04.2014), paragraphs [0039] to [0047]; fig. 8 (Family: none) | 3-9<br>1-2 |
| Y<br>A | JP 2013-171864 A (Konica Minolta, Inc.), 02 September 2013 (02.09.2013), paragraph [0030] (Family: none) | 4-9<br>1-3 |
| Y<br>A | JP 2012-168301 A (Bridgestone Corp.), 06 September 2012 (06.09.2012), paragraphs [0019] to [0040] (Family: none) | 5-9<br>1-4 |
| A | US 2014/0307178 A1 (SHENZHEN O-FILM TECH CO., LTD.), 16 October 2014 (16.10.2014), paragraphs [0052] to [0058]; fig. 2 to 5 & JP 2015-515709 A & WO 2014/166175 A1 & CN 103412668 A & TW 201439840 A & KR 10-2014-0132264 A | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2015038639 A
- JP 2009169720 A